(19) Europäisches Patentamt
European Patent Office
Office européen des brevets

(11) **EP 4 760 603 A1**

(12) **EUROPEAN PATENT APPLICATION**

(43) Date of publication:
**17.06.2026  Bulletin 2026/25**

(21) Application number: **25215979.3**

(22) Date of filing: **14.11.2025**

(51) International Patent Classification (IPC):
**G06N 10/20** $^{(2022.01)}$     **G06N 10/80** $^{(2022.01)}$
**G06N 10/60** $^{(2022.01)}$     **G06N 10/70** $^{(2022.01)}$

(52) Cooperative Patent Classification (CPC):
**G06N 10/20;** G06N 10/60; G06N 10/70; G06N 10/80

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **13.12.2024  US 202418980430**

(71) Applicant: **QUANSCIENT OY**
**33100 Tampere (FI)**

(72) Inventors:
• **Niemimäki, Ossi**
  **33100 Tampere (FI)**
• **Budinski, Ljubomir**
  **33100 Tampere (FI)**
• **Zamora-Zamora, Roberto**
  **33100 Tampere (FI)**
• **Lahtinen, Valtteri**
  **33100 Tampere (FI)**

(74) Representative: **Moosedog Oy**
**Kurjenmäenkatu 10 B 49**
**20700 Turku (FI)**

(54) **MULTI-STEP QUANTUM BASIS STATE SHIFT**

(57)     Disclosed is a method and a quantum circuit to be utilised for performing a multi-step quantum basis state shift. For a state vector space having the size of $2^{N+1}$, a full shift register comprises N+1 qubits. A last qubit ($q_{N+1}$) of the full shift register is a superposition qubit, which allows for defining a superposition of substates. The superposition qubit is used to determine which substates are to be incremented and which substates are to be decremented. Even substates to be incremented can be incremented by simply applying a step of inverting an i+1$^{th}$ qubit ($q_{i+1}$), namely a step qubit. Similarly, odd substates to be decremented can be decremented by applying the same step of inverting. Remaining steps of the quantum circuit are employed to perform a rearrangement of the even substates to be incremented, the even substates to be decremented, the odd substates to be incremented, and the odd substates to be decremented, such that applying the step of inverting performs the multi-step quantum basis state shift in one go.

FIG. 1

Processed by Luminess, 75001 PARIS (FR)

**Description**

TECHNICAL FIELD

The present disclosure relates to a method for performing a multi-step quantum basis state shift. The present disclosure also relates to a quantum computer or a quantum simulator that is configured to execute the aforementioned method. The present disclosure further relates to a quantum circuit for performing a multi-step quantum basis state shift.

BACKGROUND

In order to outperform classical computation, a quantum algorithm requires a lower scaling of computational operations with respect to a size of a problem being solved, in comparison to a classical algorithm solving the same problem. While logarithmic scaling of quantum operations (namely, gates) with respect to a number of internal qubit states is a desired characteristic for a state shift algorithm, the computational complexity of quantum algorithms varies significantly depending on the problem being solved and the computational approach to solve the problem. In general, the computational complexity is not necessarily related to the number of tensor product states, and speed-up can arise from diverse algorithmic mechanisms across different complexity classes.

Notably, a process of state shift is used as a subroutine in several quantum algorithms. Currently known quantum shift procedures can be implemented using two possible configurations: (i) a first configuration with an additional (variable) ancilla register, (ii) a second configuration without any additional (variable) ancilla register. In the first configuration, an introduction of a variable ancilla register provides logarithmic dependence. The first configuration has been disclosed in US11,694,107. On the other hand, in the second configuration, an ancilla-free approach (for example, such as a Quantum Fourier Transform (QFT)-based shift) leads to an algorithm that scales quadratically with the number of qubits, which makes the complexity poly-logarithmic in terms of the number of states. The QFT-based shift has been proposed by Shakeel in "Efficient and scalable quantum walk algorithms via the quantum fourier transform", published in Quantum Information Processing 19 (2020).

These two configurations have complementary advantages and disadvantages. Implementing the state shift using the second configuration requires less qubits to be used in a workspace, but its quantum circuit is much deeper than that of the first configuration. For example, with the QFT-based shift, the number of gates increases quadratically with the size of the state space. Moreover, the QFT-based shift relies on precise rotation and phase transition gates, which can be very sensitive to noise.

On the other hand, the first configuration has lower computational complexity and the number of gates increase only linearly with the size of the state space. It will be appreciated that although execution time is mostly device-dependent, lower computational complexity, in general, translates to smaller execution time, as less computational operations are needed. While the first configuration scales linearly, it still has high initial gate cost that strongly affects the computational complexity in practical applications. Moreover, the process of setting up the quantum circuit is quite complicated.

In order to mitigate the shortcomings and make further improvements in the state shift algorithm, further redesign and optimization of the state shift algorithm is required.

SUMMARY

The present disclosure seeks to provide a method for performing a multi-step quantum basis state shift. The present disclosure also seeks to provide a quantum computer or a quantum simulator that is configured to execute the aforementioned method. The present disclosure further seeks to provide a quantum circuit for performing a multi-step quantum basis state shift. The aim of the present disclosure is achieved by a method, a quantum computer or a quantum simulator, and a quantum circuit, as defined in the appended independent claims to which reference is made to. Advantageous features are set out in the appended dependent claims.

Throughout the description and claims of this specification, the words *"comprise", "include", "have",* and *"contain"* and variations of these words, for example *"comprising"* and *"comprises",* mean *"including but not limited to",* and do not exclude other components, items, integers or steps not explicitly disclosed also to be present. Moreover, the singular encompasses the plural unless the context otherwise requires. In particular, where the indefinite article is used, the specification is to be understood as contemplating plurality as well as singularity, unless the context requires otherwise.

BRIEF DESCRIPTION OF THE DRAWINGS

FIG. 1 is a schematic illustration of a part of a method for performing a multi-step quantum basis state shift, in accordance with an embodiment of the present disclosure;

FIGs. 2A and 2B depict a detailed diagram of a quantum circuit for performing a multi-step quantum basis state shift, in accordance with an embodiment of the present disclosure;

FIG. 2C depicts a detailed diagram of an example quantum circuit for N = 4 and i = 0, in accordance with an embodiment of the present disclosure;

FIG. 3 depicts an example of a multi-step quantum basis state shift on a two-dimensional lattice, in accordance with an embodiment of the present disclosure;

FIG. 4 depicts a detailed diagram of a quantum circuit that uses two controlled swap blocks for performing two multi-step quantum basis state shifts in two dimensions, in accordance with an embodiment of the present disclosure;

FIG. 5 depicts how the number of CX gates scales for different bidirectional shifts with a step size of one, relative to the number of qubits (N) that are used to encode a one-dimensional lattice;

FIG. 6 depicts how the total number of gates scales for a bi-directional one-dimensional quantum walk with a step size of one, relative to the number of qubits (N) that are used to encode a one-dimensional lattice;

FIG. 7 depicts how the total number of gates scales for a two-dimensional quantum walk in four directions with a step size of one, relative to the number of qubits (N) that are used to encode one side of a two-dimensional lattice;

FIG. 8 depicts how the total number of gates scales for a two-dimensional QLBM model for the ADE employed using different shifts for a propagation step, relative to the number of qubits (N) that are used to encode one side of a two-dimensional lattice; and

FIG. 9 depicts a circuit fidelity comparison of different bi-directional shifts with a step size of one, relative to the number of qubits N used to encode a one-dimensional lattice.

## DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practising the present disclosure are also possible.
In a first aspect, an embodiment of the present disclosure provides a method being executed by a quantum computer or a quantum simulator, the method comprising:

setting up a full shift register and an ancilla register for a quantum circuit to be utilised for performing a multi-step quantum basis state shift in a state vector space having a size of $2^{N+1}$, wherein the full shift register comprises N+1 qubits, wherein first N qubits ($q_1$, $q_2$,... $q_N$) of the full shift register form an array register, and a last qubit ($q_{N+1}$) of the full shift register is a superposition qubit, and the ancilla register comprises at most N-1 ancilla qubits ($a_1$,... $a_{N-1}$);

dividing an input state comprising $2^{N+1}$ array substates into a first subset of array substates that are to be incremented and a second subset of array substates that are to be decremented, by considering an array substate whose superposition qubit ($q_{N+1}$) is 0 as an array substate to be incremented, and by considering an array substate whose superposition qubit ($q_{N+1}$) is 1 as an array substate to be decremented; and

for a step size of $2^i$ in the multi-step quantum basis state shift, where a step index 'i' is a non-negative integer less than N,

for i < N - 2, setting up the quantum circuit by:

decomposing the array substates of the first subset into even substates to be incremented and odd substates to be incremented, whilst decomposing the array substates of the second subset into even substates to be decremented and odd substates to be decremented, by considering a substate whose $k^{th}$ qubit ($q_k$) is 0 as an even substate, and by considering a substate whose $k^{th}$ qubit ($q_k$) is 1 as an odd substate, wherein k is equal to i+1;

re-mapping state amplitudes of the even substates to be decremented and the odd substates to be decremented;

recursively decomposing the odd substates to be incremented into further even substates to be incremented and further odd substates to be incremented, whilst recursively decomposing the even substates to be decremented into further even substates to be decremented and further odd substates to be decremented, by considering a substate whose $k^{th}$ qubit ($q_k$) is 0 as an even substate, and by considering a substate whose $k^{th}$ qubit ($q_k$) is 1 as an odd substate, wherein k is incremented by 1 with each recursion until k reaches N-1;

re-mapping state amplitudes of the further even substates to be decremented and the further odd substates to be decremented, after each recursion;

inverting the $k+1^{th}$ qubit ($q_{k+1}$) using a k-$i^{th}$ ancilla qubit ($a_{k-i}$) of the ancilla register as a control, to swap amplitude blocks of a size $2^k$ between adjacent even substates to be decremented with respect to the $k^{th}$ qubit ($q_k$), whilst swapping amplitude blocks of a size $2^k$ between adjacent odd substates to be incremented with respect to the $k^{th}$ qubit ($q_k$), wherein k is equal to N - 1, and k is decremented by 1 with each recursion;

reversing the step of re-mapping the state amplitudes of the further even substates to be decremented and the further odd substates to be decremented;

reversing the step of recursively decomposing, wherein the step of inverting and the step of reversing the step of re-mapping are repeated prior to the reversing of each recursion of the step of recursively decomposing;

inverting the $k+1^{th}$ qubit ($q_{k+1}$) using a first ancilla qubit ($a_1$) of the ancilla register as a control, to swap amplitude blocks of a size $2^k$ between adjacent even substates to be decremented with respect to the $k^{th}$ qubit ($q_k$), whilst swapping amplitude blocks of a size $2^k$ between adjacent odd substates to be incremented with respect to the $k^{th}$ qubit ($q_k$), wherein k is equal to i+1;

reversing the step of re-mapping the state amplitudes of the even substates to be decremented and the odd substates to be decremented;

reversing the step of decomposing; and

inverting an $i+1^{th}$ qubit ($q_{i+1}$) to complete the multi-step quantum basis state shift of the state amplitudes according to the step size of $2^i$.

In a second aspect, an embodiment of the present disclosure provides a quantum computer or a quantum simulator that is configured to execute the method according to the aforementioned first aspect.

The present disclosure provides the aforementioned method and the aforementioned quantum computer or the aforementioned quantum simulator. The aforementioned method allows for performing the multi-step quantum basis state shift in the step size of $2^i$, namely a power of two. Advantageously, the multi-step quantum basis state shift can be performed in multiple shift directions in one go at a same computational complexity class as a single-step basis state shift. In this regard, certain preparatory steps are performed, to ensure a correct superposition of the "direction substates", for example, as discussed later. This allows for a significant quantum speedup. Moreover, it will be appreciated that a multi-step quantum basis state shift of any arbitrary step size can then be created by combining multi-step quantum basis state shifts that are performed using the aforementioned method.

The aforementioned method can be considered as a redesign of the first configuration (described in the Background section), wherein the method significantly lowers the initial gate cost, thereby making the parallel shift competitive with the QFT-based shift even on lower qubit numbers, while also being much simpler in its conceptual design. In particular, this allows for an easy extension to multi-stepping and higher-dimensional lattice shifts.

One of the key benefits of the aforementioned method is in a natural parallelization that arises from a superposition of array substates. Notably, the number of qubits in the full shift register depends on the size of the state vector space. In particular, for the state vector space having the size of $2^{N+1}$, the full shift register comprises N+1 qubits. Out of these N+1 qubits, the last qubit ($q_{N+1}$) of the full shift register is the superposition qubit. This superposition qubit allows for defining the superposition of two array substates that are in orthogonal directions (namely, with respect to increment and decrement). In this regard, the step of dividing the input state involves using the superposition qubit to determine which array substates are to be incremented (namely, the first subset) and which array substates are to be decremented (namely, the second subset). Each array substate whose superposition qubit ($q_{N+1}$) is 0 is considered as an array substate to be incremented, while each array substate whose superposition qubit ($q_{N+1}$) is 1 is considered as an array substate to be decremented. As a result, the number of array substates in the first subset and the number of array substates in the second subset is equal to $2^N$. The aforesaid first subset and the aforesaid second subset are linked in a manner that at each array point that is defined by basis states of the array register (which is formed by the first N qubits ($q_1$, $q_2$,... $q_N$) of the full shift register), there is a state amplitude that is being shifted "up" and a state amplitude that is being shifted "down". This manifests as having two layers of state amplitudes on top of a position space defined by the array register, which could, for example, be interpreted as a regular polygonal lattice. This means that an overall amount of data in the state vector space is $2^{N+1}$ state amplitudes, which is also referred to as the size of the state vector space, wherein $2^N$ array substates that are marked with the superposition qubit as 0 are to be incremented, and $2^N$ array substates that are marked with the superposition qubit as 1 are to be decremented. Thus, the first subset of array substates (to be incremented) and the second subset of array substates (to be decremented) refer to a superposition of two probability distributions over the same position space defined by the array register. The array substates of the first subset and the array substates of the second subset are defined using the array register, namely the first N qubits ($q_1$, $q_2$,... $q_N$) of the full shift register.

It is noteworthy that even substates to be incremented (by a step size of $2^i$) can be incremented by simply applying the step of inverting the i+1$^{th}$ qubit ($q_{i+1}$), which is also referred to as the step qubit. Similarly, the odd substates to be decremented (by a step size of $2^i$) can be decremented by applying the same step of inverting the i+1$^{th}$ qubit ($q_{i+1}$), namely the step qubit. Remaining steps of the quantum circuit are employed to perform a rearrangement of the even substates to be decremented and the odd substates to be incremented, such that applying the step of inverting the i+1$^{th}$ qubit ($q_{i+1}$) (namely, the step qubit) performs the multi-step quantum basis state shift in one go. Notably, the step of inverting inherently takes care of the even substates to be incremented and the odd substates to be decremented; therefore, no special rearrangement is required to be performed for these. Throughout the present disclosure, the term "i+1$^{th}$" refers to $(i+1)^{th}$; parentheses have been avoided for the sake of convenience and improved readability. Similar notation has been used for other similar terms also.

Moreover, the number of ancilla qubits in the ancilla register depends on the step size of the multi-step quantum basis state shift. Thus, the ancilla register comprises at most N-1 ancilla qubits. The step size is defined as $2^i$, namely using the step index 'i', which is a non-negative integer less than N. The steps of the method for performing the multi-step quantum basis state shift differ depending on the step size. In other words, the steps of the method depend on the value of the step index 'i', as will be described in detail now.

For illustration purposes, there will be now described how the quantum circuit is set up in the aforementioned method. For i < N - 2, the quantum circuit is set up by performing the following steps:

Step (#1) of decomposing: The array substates of the first subset (namely, the array substates to be incremented) are decomposed into the even substates to be incremented and the odd substates to be incremented, while the array substates of the second subset (namely, the array substates to be decremented) are decomposed into the even substates to be decremented and the odd substates to be decremented. In this regard, a substate whose k$^{th}$ qubit ($q_k$) is 0 is considered as an even substate, while a substate whose k$^{th}$ qubit ($q_k$) is 1 is considered as an odd substate. For this step of decomposing, k is taken to be equal to i+1. It will be appreciated that i+1 is merely an initial value of k, and the value of k increments recursively with subsequent recursive steps as explained below. The k$^{th}$ qubit ($q_k$) is referred to as a split qubit, wherein k is referred to as a split index. It will be appreciated that at the step (#1) of decomposing, the array substates are divided into smaller substates. With each subsequent decomposing, the substates are divided into further smaller substates; at the finest level, the smallest substates comprise single amplitudes corresponding to the basis states.

Step (#2) of re-mapping: The state amplitudes of the even substates to be decremented and the odd substates to be decremented are then re-mapped. Such re-mapping does not affect any qubit other than the k$^{th}$ qubit ($q_k$) of the array register. Such re-mapping can also be referred to as flipping the even substate to be decremented and the odd substate to be decremented. It will be appreciated that the flipping does not affect the data; in other words, the data is retained in the state amplitudes.

Step (#3) of recursively decomposing: The odd substates to be incremented are recursively decomposed into further even substates to be incremented and further odd substates to be incremented. Likewise, the even substates to be decremented are recursively decomposed into further even substates to be decremented and further odd substates to be decremented. In this regard, a substate whose k$^{th}$ qubit ($q_k$) is 0 is considered as an even substate, while a substate whose k$^{th}$ qubit ($q_k$) is 1 is considered as an odd substate. With each recursion of the step of recursively decomposing, the value of k is incremented by 1 until k reaches N-1. Thus, this step of recursively decomposing is performed depending on the value of i, namely till k reaches N - 1 (from the initial value of i+1).

Step (#4) of re-mapping, after each recursion: The state amplitudes of the further even substates to be decremented and the further odd substates to be decremented are re-mapped, after each recursion of the step (#3) of recursively decomposing. Such re-mapping does not affect any qubit other than the k$^{th}$ qubit ($q_k$) of the array register. As mentioned earlier, the further even substate to be decremented and the further odd substate to be decremented are merely flipped, whilst retaining the data in the state amplitudes.

Step (#5) of inverting: The k+1$^{th}$ qubit ($q_{k+1}$) is inverted using the k-i$^{th}$ ancilla qubit ($a_{k-i}$) of the ancilla register as a control, thereby swapping the amplitude blocks of the size $2^k$ between adjacent even substates to be decremented with respect to the $k^{th}$ qubit ($q_k$), whilst swapping the amplitude blocks of the size $2^k$ between adjacent odd substates to be incremented with respect to the $k^{th}$ qubit ($q_k$). This step of inverting is initially performed using the value of k that is equal to N - 1.

It will be appreciated here that the size of the swapping depends on the split index 'k', as a quantum gate employed for inverting (also referred to as the "inverter") is based on the $k+1^{th}$ qubit ($q_{k+1}$). Thus, for the step (#5) of inverting, the inverter is applied on the $N^{th}$ qubit (namely, the last qubit of the array register) because this step of inverting starts with k = N - 1. In other words, the step (#5) of inverting involves the swapping of the amplitude blocks of the size $2^{N-1}$ for those even substates to be decremented that are defined with respect to the $N-1^{th}$ qubit, as well as the swapping of the amplitude blocks of the size $2^{N-1}$ for those odd substates to be incremented that are defined with respect to the $N-1^{th}$ qubit.

The inverter is applied using the $k-i^{th}$ ancilla qubit ($a_{k-i}$) of the ancilla register as the control. This means that the aforesaid swapping does not shift a complete quantum state, but only swaps specific substates in a particular position of a decomposition sequence, wherein this particular position is defined by the $k^{th}$ qubit ($q_k$). This is also referred to as "substate shift" throughout the present disclosure.

As mentioned earlier, the number of ancilla qubits in the ancilla register depends on the step size of the multi-step quantum basis state shift. For example, if the step size is 1, then i is equal to 0 (zero), as the step size = $2^i$ = 1. In such a case, the $k-i^{th}$ ancilla qubit ($a_{k-i}$) refers to an $N-1^{th}$ ancilla qubit ($a_{N-1}$) of the ancilla register. Thus, at most N-1 ancilla qubits are required. For larger step sizes (namely, step sizes larger than 1), lesser number of ancilla qubits would be required, because i would be greater than 0 (zero). In particular, the number of ancilla qubits required is equal to N - i - 1.

Step (#6) of reversing the aforesaid step (#4) of re-mapping: At this step, the aforesaid step (#4) of re-mapping is reversed. In other words, the flip performed at the step (#4) is reversed.

Step (#7) of reversing the aforesaid step (#3) of recursively decomposing: At this step, the aforesaid step (#3) of recursively decomposing is reversed recursively. It will be appreciated that the step of reversing the step of recursively decomposing can also be referred to as the step of recursively re-composing. The aforesaid step (#5) of inverting and the aforesaid step (#6) of reversing the step of re-mapping are repeated prior to the step (#7) of reversing of each recursion of the step of recursively decomposing. In other words, the step (#5) of inverting and the step (#6) of reversing the re-mapping are performed prior to each recursion of the step (#7) of reversing the step of recursively decomposing. It will be appreciated that the value of k is then decremented by 1 with each recursion of the step (#7), until k reaches i+1.

Step (#8) of inverting, prior to reversing the step (#1) of decomposing:
When the value of k reaches i+1, the $k+1^{th}$ qubit ($q_{k+1}$) is inverted using the first ancilla qubit ($a_1$) of the ancilla register as a control, thereby swapping the amplitude blocks of the size $2^k$ between adjacent even substates to be decremented with respect to the $k^{th}$ qubit ($q_k$), whilst swapping the amplitude blocks of the size $2^k$ between adjacent odd substates to be incremented with respect to the $k^{th}$ qubit ($q_k$).

It will be appreciated here that the size of the swapping (namely, the substate shift) depends on the split index 'k', as a quantum gate employed for inverting (namely, the "inverter") is based on the $k+1^{th}$ qubit ($q_{k+1}$). It will be appreciated that as the value of k has reached i+1, the $k+1^{th}$ qubit ($q_{k+1}$) refers to an $i+2^{th}$ qubit ($q_{i+2}$) of the array register. As the inverter is applied using the $k-i^{th}$ ancilla qubit ($a_{k-i}$) of the ancilla register as the control, it means that the inverter is applied using the first ancilla qubit ($a_1$) of the ancilla register. This means that the aforesaid swapping does not shift a complete quantum state, but only swaps specific substates in a particular position of the decomposition sequence, wherein this particular position is defined by the $k^{th}$ qubit ($q_k$), namely the $i+1^{th}$ qubit ($q_{i+1}$).

Step (#9) of reversing the aforesaid step (#2) of re-mapping: At this step, the aforesaid step (#2) of re-mapping is reversed. In other words, the flip performed at the step (#2) is reversed. This step is also performed prior to reversing the step (#1) of decomposing.

Step (#10) of reversing the aforesaid step (#1) of decomposing: At this step, the step (#1) of decomposing is reversed. It will be appreciated that the step of reversing the step of decomposing can also be referred to as the step of re-composing.

Step (#11) of final inverting: The $i+1^{th}$ qubit ($q_{i+1}$) (namely, the step qubit) is inverted to complete the multi-step quantum basis state shift of the state amplitudes according to the step size of $2^i$. This step (#11) of final inverting completes the multi-step quantum basis state shift for the full state of the array register that is prepared for by earlier sequence of shifts of the substates (namely, previous steps of inverting). The step (#11) of final inverting swaps the amplitude blocks of the size $2^i$ between adjacent even substates to be decremented with respect to the $i^{th}$ qubit ($q_i$), whilst swapping the amplitude blocks of the size $2^i$ between adjacent odd substates to be incremented with respect to the $i^{th}$ qubit ($q_i$).

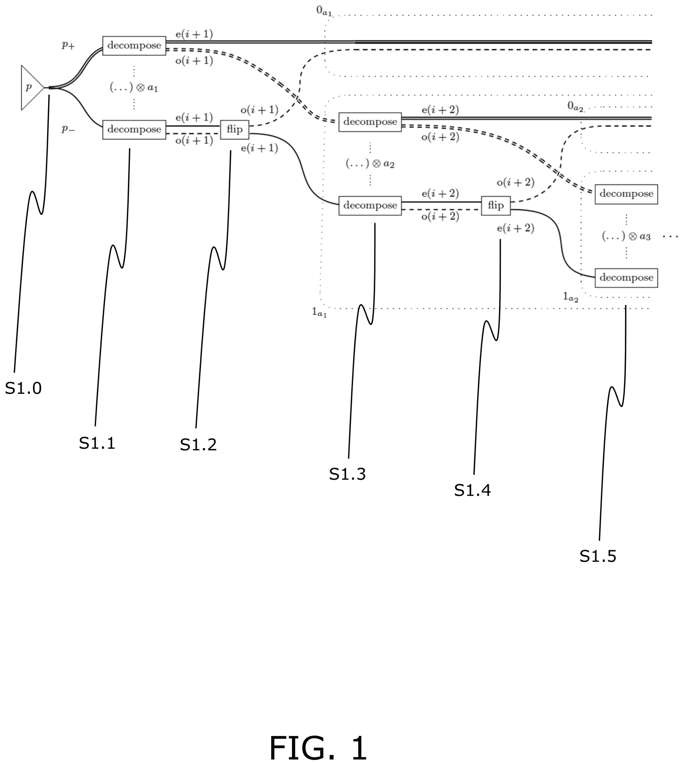

FIG. 1 is a schematic illustration of a part of the aforementioned method, in accordance with an embodiment of the present disclosure. Said part comprises the following steps:
Step **S1.0** depicts the aforesaid step of dividing the input state **p** (comprising the $2^{N+1}$ array substates) into the first subset **p+** of array substates that are to be incremented and the second subset **p-** of array substates that are to be decremented. In FIG. 1, double lines denote substates that are to be incremented, while single lines denote substates that are to be decremented.

Step **S1.1** depicts the aforesaid step (#1) of decomposing. In FIG. 1, the even substates are marked with respect to the split qubit, namely the $k^{th}$ qubit ($q_k$). Thus, e(k) depicts the even substates, while o(k) depicts the odd substates. The value of k is initially equal to i+1. In other words, the step (#1) of decomposition begins with the split index k = i + 1. In FIG. 1, dashed lines are used for denoting the odd substates, while solid lines are used for denoting the even substates.

Step **S1.2** depicts the aforesaid step (#2) of re-mapping. It will be appreciated that said re-mapping is marked using the term "flip" in FIG. 1. The term "re-mapping" and "flipping" have been used interchangeably throughout the present disclosure. The value of k is equal to i+1 till this step.

Step **S1.3** depicts a first recursion of the aforesaid step (#3) of recursively decomposing. The value of k is incremented by 1 with each recursion.

Step **S1.4** depicts the aforesaid step (#4) of re-mapping, which is performed after the first recursion of the step (#3) of recursively decomposing.

Step **S1.5** depicts a second recursion of the aforesaid step (#3) of recursively decomposing. The method then continues as explained earlier. For example, step **S1.5** is followed by the aforesaid step (#4) of re-mapping, which is performed after the second recursion of the step (#3) of recursively decomposing. The step (#3) of recursively decomposing and the step (#4) of re-mapping are performed until the split index 'k' reaches N - 1.

Thereafter, controlled inverting is performed as explained earlier, to shift decomposed substates while reversing a cascade of steps till k reaches i+1 again. However, for the sake of simplicity, FIG. 1 does not depict subsequent steps of the method that are performed after the step **S1.5.** As shown in FIG. 1, a cascade of ancilla qubits of the ancilla register implements pairs of even substates and odd substates in preparation for the multi-step quantum basis state shift.

It will be appreciated that the aforementioned method has been explained for i < N - 2 till now. Different steps may be performed for other values of the step index 'i', as will be explained in detail below.

Optionally, the method further comprises:

for i = N - 2, setting up the quantum circuit by:

decomposing the array substates of the first subset into even substates to be incremented and odd substates to be incremented, whilst decomposing the array substates of the second subset into even substates to be decremented and odd substates to be decremented, by considering a substate whose $i+1^{th}$ qubit ($q_{i+1}$) is 0 as an even substate, and by considering a substate whose $i+1^{th}$ qubit ($q_{i+1}$) is 1 as an odd substate;

re-mapping state amplitudes of the even substates to be decremented and the odd substates to be decremented;

inverting the $i+2^{th}$ qubit ($q_{i+2}$) using the first ancilla qubit ($a_1$) of the ancilla register as a control, to swap amplitude blocks of a size $2^{i+1}$ between adjacent even substates to be decremented with respect to the $i+1^{th}$ qubit ($q_{i+1}$), whilst swapping amplitude blocks of a size $2^{i+1}$ between adjacent odd substates to be incremented with respect to the $i+1^{th}$ qubit ($q_{i+1}$);

reversing the step of re-mapping the state amplitudes of the even substates to be decremented and the odd substates to be decremented;

reversing the step of decomposing; and

inverting the $i+1^{th}$ qubit ($q_{i+1}$) to complete the multi-step quantum basis state shift of the state amplitudes according to the step size of $2^i$.

Notably, for i = N - 2, the steps are performed as follows:

The aforesaid step (#1) of decomposing is performed, and no recursive decomposition is performed. This is because the initial value of k (which is taken to be equal to i+1) comes out to be N - 1. At this step (#1), the array substates of the first subset (namely, the array substates to be incremented) are decomposed into the even substates to be incremented and the odd substates to be incremented, while the array substates of the second subset (namely, the array substates to be decremented) are decomposed into the even substates to be decremented and the odd substates to be decremented. In this regard, a substate whose $i+1^{th}$ qubit ($q_{i+1}$), namely the $k^{th}$ qubit ($q_k$), is 0 is considered as an even substate, while a substate whose $i+1^{th}$ qubit ($q_{i+1}$), namely the $k^{th}$ qubit ($q_k$), is 1 is considered as an odd substate.

Subsequently, the aforesaid step (#2) of re-mapping is performed, wherein the state amplitudes of the even substates to be decremented and the odd substates to be decremented are re-mapped.

The step (#3) of recursively decomposing, the step (#4) of re-mapping after each recursion, the step (#5) of inverting, the step (#6) of reversing the step of re-mapping, and the step (#7) of reversing the step of recursively decomposing are skipped for i = N - 2.

The aforesaid step (#8) of inverting is performed. As the value of k is i+1, the $i+2^{th}$ qubit ($q_{i+2}$), namely the $k+1^{th}$ qubit ($q_{k+1}$), is inverted using the first ancilla qubit ($a_1$) of the ancilla register as a control. As a result, the amplitude blocks of

the size $2^{i+1}$ are swapped between adjacent even substates to be decremented with respect to the $i+1^{th}$ qubit ($q_{i+1}$), namely the $k^{th}$ qubit ($q_k$). Likewise, the amplitude blocks of the size $2^{i+1}$ are swapped between adjacent odd substates to be incremented with respect to the $i+1^{th}$ qubit ($q_{i+1}$), namely the $k^{th}$ qubit ($q_k$).

The aforesaid step (#9) of reversing the aforesaid step (#2) of re-mapping is then performed.

Subsequently, the aforesaid step (#10) of reversing the aforesaid step (#1) of decomposing is performed.

Finally, the aforesaid step (#11) of final inverting is performed, wherein the $i+1^{th}$ qubit ($q_{i+1}$) is inverted to complete the multi-step quantum basis state shift of the state amplitudes according to the step size of $2^i$.

Optionally, the method further comprises:

for i = N - 1, setting up the quantum circuit by:

inverting the $i+1^{th}$ qubit ($q_{i+1}$) to complete the multi-step quantum basis state shift of the state amplitudes according to the step size of $2^i$.

Notably, for i = N - 1, only the step (#11) of final inverting is performed, wherein the $i+1^{th}$ qubit ($q_{i+1}$) is inverted to complete the multi-step quantum basis state shift of the state amplitudes according to the step size of $2^i$. It will be appreciated that i = N - 1 corresponds to a largest possible step size for the state vector space having the size of $2^{N+1}$. This is because the step size $2^i$ is exactly half of the size of the array register (namely, $2^N$), and flipping the most significant qubit on the array register amounts to shifting in the two directions.

For illustration purposes only, there will now be described an example quantum circuit that can be set up for i < N - 2 or i = N - 2. Optionally, the quantum circuit comprises in a sequential order:

a beginning segment comprising two CX gates;

optionally, a middle segment comprising multiple CX gates and multiple two-controlled gates; and

an ending segment comprising three CX gates and an X gate.

It will be appreciated that the two-controlled gates are also referred to as Toffoli gates. It will also be appreciated that the middle segment is optional, because for i = N - 2, the quantum circuit does not comprise the middle segment. This middle segment corresponds to the aforementioned step (#3) of recursively decomposing, the step (#4) of re-mapping after each recursion, the step (#5) of inverting, the step (#6) of reversing the step of re-mapping, and the step (#7) of reversing the step of recursively decomposing. As mentioned earlier, these steps are skipped for i = N - 2. In other words, for i = N - 2, the quantum circuit comprises in a sequential order:

the beginning segment comprising the two CX gates; and

the ending segment comprising the three CX gates and the X gate.

Optionally, the two CX gates of the beginning segment are applied in a sequential order of:

a CX gate that uses the $i+1^{th}$ qubit ($q_{i+1}$) of the array register as a control corresponding to a state of |1>, and a first ancilla qubit ($a_1$) of the ancilla register as a target; and

a CX gate that uses the superposition qubit ($q_{N+1}$) of the full shift register as a control corresponding to a state of |1>, and the first ancilla qubit ($a_1$) of the ancilla register as a target.

The first CX gate (in the sequential order) from amongst the two CX gates of the beginning segment is applied to perform the step (#1) of decomposing. As mentioned earlier, at the step (#1) of decomposing, the array substates of the first subset (namely, the array substates to be incremented) are decomposed into the even substates to be incremented and the odd substates to be incremented, while the array substates of the second subset (namely, the array substates to be decremented) are decomposed into the even substates to be decremented and the odd substates to be decremented. In this regard, a substate whose $k^{th}$ qubit ($q_k$) is 0 is considered as an even substate, while a substate whose $k^{th}$ qubit ($q_k$) is 1 is considered as an odd substate. For this step of decomposing, k is taken to be equal to i+1; thus, the first CX gate of the beginning segment uses the $i+1^{th}$ qubit ($q_{i+1}$) of the array register as the control.

The last CX gate (in the sequential order) from amongst the two CX gates of the beginning segment is applied to perform the step (#2) of re-mapping. As mentioned earlier, at the step (#2) of re-mapping, the state amplitudes of the even substates to be decremented and the odd substates to be decremented are re-mapped. Thus, the last CX gate of the beginning segment uses the superposition qubit ($q_{N+1}$) of the full shift register as the control.

Moreover, optionally, the three CX gates of the ending segment are applied in a sequential order of:

a CX gate that uses the first ancilla qubit ($a_1$) of the ancilla register as a control corresponding to a state of |1>, and an i+2th qubit ($q_{i+2}$) of the array register as a target;

a CX gate that uses the superposition qubit ($q_{N+1}$) of the full shift register as a control corresponding to a state of |1>, and the first ancilla qubit ($a_1$) of the ancilla register as a target; and

a CX gate that uses the i+1th qubit ($q_{i+1}$) of the array register as a control corresponding to a state of |1>, and the first ancilla qubit ($a_1$) of the ancilla register as a target,

wherein the X gate is applied to the i+1th qubit ($q_{i+1}$) of the array register.

The first CX gate (in the sequential order) from amongst the three CX gates of the ending segment is applied to perform the step (#8) of inverting, that is performed prior to reversing the step (#1) of decomposing. As mentioned earlier, the value of k reaches i+1 again; thus, at the step (#8) of inverting, the k+1th qubit ($q_{k+1}$) (namely, the i+2th qubit ($q_{i+2}$)) is inverted using the first ancilla qubit ($a_1$) of the ancilla register as the control. As a result, the amplitude blocks of the size $2^{i+1}$ are swapped between adjacent even substates to be decremented with respect to the i+1th qubit ($q_{i+1}$), and the amplitude blocks of the size $2^{i+1}$ are swapped between adjacent odd substates to be incremented with respect to the i+1th qubit ($q_{i+1}$).

The middle CX gate (in the sequential order) from amongst the three CX gates of the ending segment is applied to perform the step (#9) of reversing of the step (#2) of re-mapping the state amplitudes. Thus, the middle CX gate of the ending segment uses the superposition qubit ($q_{N+1}$) of the full shift register as the control. Notably, the same qubit, namely the superposition qubit ($q_{N+1}$) of the full shift register is used as the control by the last CX gate of the beginning segment, which is applied to perform the aforesaid step (#2) of re-mapping.

The last CX gate (in the sequential order) from amongst the three CX gates of the ending segment is applied to perform the aforesaid step (#10) of reversing the aforesaid step (#1) of decomposing, namely the step of re-composing. Thus, the last CX gate of the ending segment uses the i+1th qubit ($q_{i+1}$) of the array register as the control. Notably, the same qubit, namely the i+1th qubit ($q_{i+1}$) of the array register is used as the control by the first CX gate of the beginning segment, which is applied to perform the aforesaid step (#1) of decomposing.

The X gate of the ending segment is applied to perform the aforementioned step (#11) of final inverting. As mentioned earlier, at the step (#11) of final inverting, the i+1th qubit ($q_{i+1}$) is inverted to complete the multi-step quantum basis state shift of the state amplitudes according to the step size of $2^i$. Thus, the X gate is applied to the i+1th qubit ($q_{i+1}$) of the array register.

Furthermore, optionally, the middle segment comprises one or more sets of CX gates and two-controlled gates. The multiple CX gates and the multiple two-controlled gates of the middle segment are in the form of the one or more sets of CX gates and two-controlled gates. In this regard, a number of sets in the middle segment depends on a number of recursions of the step of recursively decomposing. In other words, the number of sets in the middle segment (and the number of recursions of the step of recursively decomposing) depend on the value of i, because a number of increments after which k reaches N - 1 from the initial value of i+1.

A given set (from amongst the one or more sets) corresponding to a given recursion comprises in a sequential order:

a first CX gate that uses the superposition qubit ($q_{N+1}$) of the full shift register as a control corresponding to a state of |1>, and a kth qubit ($q_k$) of the array register as a target;

a first two-controlled gate that uses the kth qubit ($q_k$) of the array register and a k-i-1th ancilla qubit ($a_{k-i-1}$) of the ancilla register as controls corresponding to a state of |1>, and a k-ith ancilla qubit ($a_{k-i}$) of the ancilla register as a target;

a second CX gate that uses the k-ith ancilla qubit ($a_{k-i}$) of the ancilla register as a control corresponding to a state of |1>, and an k+1th qubit ($q_{k+1}$) of the array register as a target;

a second two-controlled gate that uses the kth qubit ($q_k$) of the array register and the k-i-1th ancilla qubit ($a_{k-i-1}$) of the ancilla register as controls corresponding to a state of |1>, and the k-ith ancilla qubit ($a_{k-i}$) of the ancilla register as a target; and

a third CX gate that uses the superposition qubit ($q_{N+1}$) of the full shift register as a control corresponding to a state of |1>, and the kth qubit ($q_k$) of the array register as a target.

The first CX gate in the given set of the middle segment is applied to perform the step of re-mapping. In a first set of the middle segment (from amongst the one or more sets of CX gates and two-controlled gates in the middle segment), the first CX gate is applied to perform the step (#2) of re-mapping. At the step (#2) of re-mapping, the state amplitudes of the even substates to be decremented and the odd substates to be decremented are re-mapped. In order to perform the step (#2) of re-mapping, the first CX gate in the first set of the middle segment is applied by using the superposition qubit ($q_{N+1}$) of the full shift register as the control and the $k^{th}$ qubit ($q_k$) of the array register as the target.

In any other set of the middle segment (namely, other than the first set of the middle segment), the first CX gate is applied to perform the step (#4) of re-mapping, after each recursion of the step (#3) of recursively decomposing. At the step (#4) of re-mapping, the state amplitudes of the further even substates to be decremented and the further odd substates to be decremented are re-mapped. In order to perform the step (#4) of re-mapping, the first CX gate is applied by using the superposition qubit ($q_{N+1}$) of the full shift register as the control and the $k^{th}$ qubit ($q_k$) of the array register as the target. Note that with each recursion, the value of k also changes, thereby allowing the step of re-mapping to be performed for further smaller substates.

The first two-controlled gate in the given set of the middle segment is applied to perform the step (#3) of recursively decomposing. At the step (#3) of recursively decomposing, the odd substates to be incremented are recursively decomposed into further even substates to be incremented and further odd substates to be incremented, while the even substates to be decremented are recursively decomposed into further even substates to be decremented and further odd substates to be decremented. In this regard, a substate whose $k^{th}$ qubit ($q_k$) is 0 is considered as an even substate, while a substate whose $k^{th}$ qubit ($q_k$) is 1 is considered as an odd substate. It will be appreciated that with each recursion of the step (#3) of recursively decomposing, the value of k is incremented by 1 until k reaches N-1. In other words, the given set (corresponding to the given recursion) has its own value of k, because k increments with each recursion. In order to perform a given recursion of the step (#3) of recursively decomposing, the first two-controlled gate in the given set of the middle segment is applied by using the $k^{th}$ qubit ($q_k$) of the array register and the $k\text{-}i\text{-}1^{th}$ ancilla qubit ($a_{k-i-1}$) of the ancilla register as the controls, and the $k\text{-}i^{th}$ ancilla qubit ($a_{k-i}$) of the ancilla register as the target.

The second CX gate in the given set of the middle segment is applied to perform the step (#5) of inverting. At the step (#5) of inverting, the $k+1^{th}$ qubit ($q_{k+1}$) is inverted using the $k\text{-}i^{th}$ ancilla qubit ($a_{k-i}$) of the ancilla register as the control. This swaps the amplitude blocks of the size $2^k$ between adjacent even substates to be decremented with respect to the $k^{th}$ qubit ($q_k$), whilst swapping the amplitude blocks of the size $2^k$ between adjacent odd substates to be incremented with respect to the $k^{th}$ qubit ($q_k$). In order to perform the step (#5) of inverting, the second CX gate in the given set of the middle segment is applied by using the $k\text{-}i^{th}$ ancilla qubit ($a_{k-i}$) of the ancilla register as the control, and the $k+1^{th}$ qubit ($q_{k+1}$) of the array register as the target. It will be appreciated that as this step of inverting is initially performed using the value of k that is equal to N - 1, the first set (from amongst the one or more sets of CX gates and two-controlled gates in the middle segment) uses N - 1 as the value of k. For subsequent sets (in the one or more sets of CX gates and two-controlled gates in the middle segment), the value of k is decremented by 1 till k reaches i+1.

The second two-controlled gate in the given set of the middle segment is applied to perform the step (#6) of reversing of the aforesaid step (#4) of re-mapping. In order to perform the step (#6) of reversing of the step (#4) of re-mapping, the second two-controlled gate in the given set of the middle segment is applied by using the $k^{th}$ qubit ($q_k$) of the array register and the $k\text{-}i\text{-}1^{th}$ ancilla qubit ($a_{k-i-1}$) of the ancilla register as the controls, and the $k\text{-}i^{th}$ ancilla qubit ($a_{k-i}$) of the ancilla register as the target.

The third CX gate in the given set of the middle segment is applied to perform the step (#7) of reversing the aforesaid step (#3) of recursively decomposing. In order to perform the step (#7) of re-composing, the third CX gate in the given set of the middle segment is applied by using the superposition qubit ($q_{N+1}$) of the full shift register as the control, and the $k^{th}$ qubit ($q_k$) of the array register as the target. As mentioned earlier, the value of k is decremented by 1 with each recursion of the step (#7), until k reaches i+1.

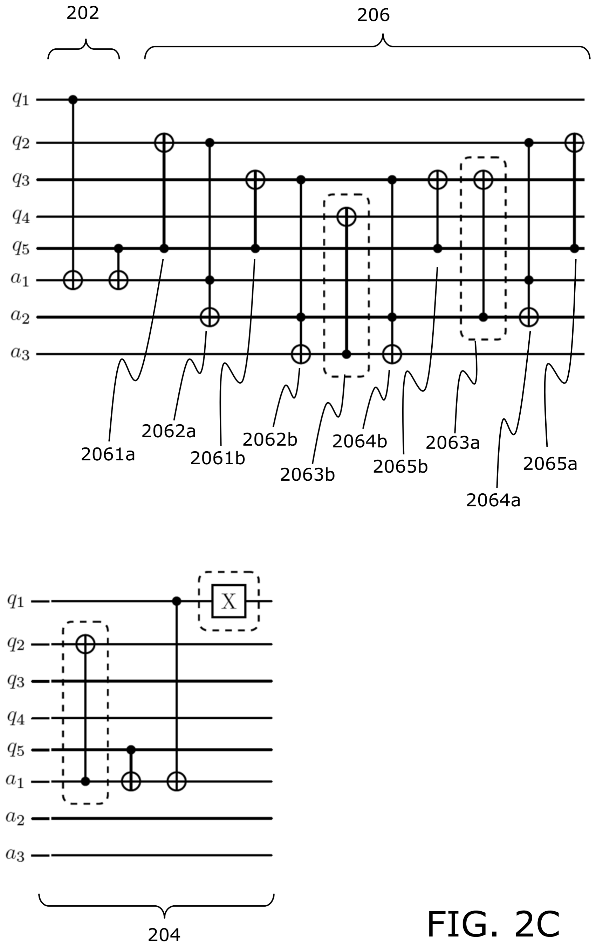

It will be appreciated that in the middle segment, the one or more sets of CX gates and two-controlled gates are not arranged one after another in sequence. In order to perform the recursions properly, the one or more sets are arranged in a specific way. In this regard, an $M+1^{th}$ set corresponding to an $M+1^{th}$ recursion is appended after a corresponding first two-controlled gate of an $M^{th}$ set corresponding to an $M^{th}$ recursion. This has been illustrated in conjunction with FIG. 2C later.

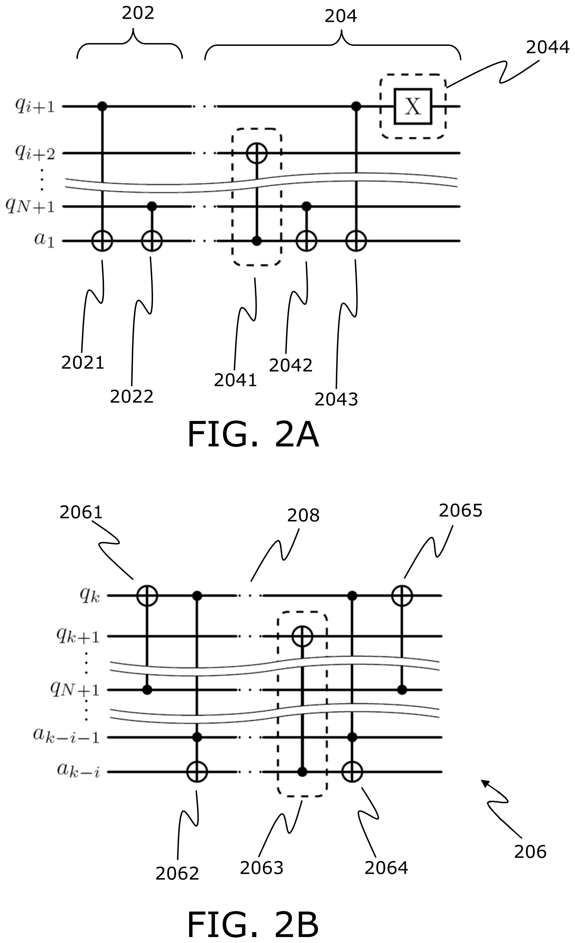

Referring now to FIGs. 2A and 2B, depicted is a detailed diagram of a quantum circuit, in accordance with an embodiment of the present disclosure. The quantum circuit is executed by a quantum computer or a quantum simulator. The quantum circuit comprises a full shift register and an ancilla register to be utilised for performing a multi-step quantum basis state shift in a state vector space having a size of $2^{N+1}$. The full shift register comprises N+1 qubits, wherein first N qubits (**$q_1$, $q_2$,... $q_N$**) of the full shift register form an array register, and a last qubit (**$q_{N+1}$**) of the full shift register is a superposition qubit. The ancilla register comprises at most N-1 ancilla qubits (**$a_1$,... $a_{N-1}$**). The quantum circuit comprises in a sequential order:

a beginning segment **202** comprising two CX gates **2021-2022;**

optionally, a middle segment **206** comprising multiple CX gates **2061, 2063** and **2065,** and multiple two-controlled gates **2062** and **2064;** and

an ending segment **204** comprising three CX gates **2041-2043** and an X gate **2044.**

There will be now described the quantum circuit for a step size of $2^i$ in the multi-step quantum basis state shift, where a step index 'i' is a non-negative integer less than N.

Optionally, as shown in FIG. 2A, for i < N - 2 or i = N - 2, the two CX gates **2021-2022** of the beginning segment **202** are applied in a sequential order of:

a CX gate **2021** that uses the $i+1^{th}$ qubit $q_{i+1}$ of the array register as a control corresponding to a state of |1>, and a first ancilla qubit $a_1$ of the ancilla register as a target; and

a CX gate **2022** that uses the superposition qubit $q_{N+1}$ of the full shift register as a control corresponding to a state of |1>, and the first ancilla qubit $a_1$ of the ancilla register as a target.

Optionally, as shown in FIG. 2A, for i < N - 2 or i = N - 2, the three CX gates **2041-2043** of the ending segment **204** are applied in a sequential order of:

a CX gate **2041** that uses the first ancilla qubit $a_1$ of the ancilla register as a control corresponding to a state of |1>, and an $i+2^{th}$ qubit $q_{i+2}$ of the array register as a target;

a CX gate **2042** that uses the superposition qubit $q_{N+1}$ of the full shift register as a control corresponding to a state of |1>, and the first ancilla qubit $a_1$ of the ancilla register as a target; and

a CX gate **2043** that uses the $i+1^{th}$ qubit $q_{i+1}$ of the array register as a control corresponding to a state of |1>, and the first ancilla qubit $a_1$ of the ancilla register as a target,

wherein the X gate **2044** is applied to the $i+1^{th}$ qubit $q_{i+1}$ of the array register.

Optionally, for i < N - 2, the middle segment **206** comprises one or more sets of CX gates and two-controlled gates, wherein a number of sets in the middle segment **206** depends on a number of recursions, wherein k is initially equal to i+1, and k is incremented by 1 with each recursion until k reaches N-1. In FIG. 2B, a given set corresponding to a given recursion has been shown, for illustration purposes. The given set comprises in a sequential order:

a first CX gate **2061** that uses the superposition qubit $q_{N+1}$ of the full shift register as a control corresponding to a state of |1>, and a $k^{th}$ qubit $q_k$ of the array register as a target;

a first two-controlled gate **2062** that uses the $k^{th}$ qubit $q_k$ of the array register and a $k-i-1^{th}$ ancilla qubit $a_{k-i-1}$ of the ancilla register as controls corresponding to a state of |1>, and a $k-i^{th}$ ancilla qubit $a_{k-i}$ of the ancilla register as a target;

a second CX gate **2063** that uses the $k-i^{th}$ ancilla qubit $a_{k-i}$ of the ancilla register as a control corresponding to a state of |1>, and an $k+1^{th}$ qubit $q_{k+1}$ of the array register as a target;

a second two-controlled gate **2064** that uses the $k^{th}$ qubit $q_k$ of the array register and the $k-i-1^{th}$ ancilla qubit $a_{k-i-1}$ of the ancilla register as controls corresponding to a state of |1>, and the $k-i^{th}$ ancilla qubit $a_{k-i}$ of the ancilla register as a target; and

a third CX gate **2065** that uses the superposition qubit $q_{N+1}$ of the full shift register as a control corresponding to a state of |1>, and the $k^{th}$ qubit $q_k$ **of** the array register as a target.

In the middle segment **206,** an $M+1^{th}$ set corresponding to an $M+1^{th}$ recursion is appended after a corresponding first two-controlled gate of an $M^{th}$ set corresponding to an $M^{th}$ recursion, as indicated by dashed lines **208.**

For illustration purposes only, FIG. 2C depicts a detailed diagram of an example quantum circuit for N = 4 and i = 0, in accordance with an embodiment of the present disclosure. The example quantum circuit is to be utilised for performing a multi-step quantum basis state shift in a state vector space having a size of $2^{N+1} = 2^5 = 32$. The full shift register comprises five qubits, wherein first four qubits $(q_1, q_2, q_3, q_4)$ of the full shift register form the array register, and the last qubit $(q_5)$ of the full shift register is the superposition qubit. The ancilla register comprises three ancilla qubits $(a_1, a_2, a_3)$. The example quantum circuit comprises in a sequential order:

a beginning segment **202** comprising two CX gates;

a middle segment **206** comprising two sets of CX gates and two-controlled gates; and

an ending segment **204** comprising three CX gates and an X gate.

As shown in FIG. 2C, the two CX gates of the beginning segment **202** are applied in a sequential order of:

a CX gate that uses a first qubit $q_1$ of the array register as a control corresponding to a state of |1>, and a first ancilla qubit $a_1$ of the ancilla register as a target; and
a CX gate that uses the superposition qubit $q_5$ of the full shift register as a control corresponding to a state of |1>, and the first ancilla qubit $a_1$ of the ancilla register as a target.

As shown in FIG. 2C, the three CX gates of the ending segment **204** are applied in a sequential order of:

a CX gate that uses the first ancilla qubit $a_1$ of the ancilla register as a control corresponding to a state of |1>, and a second qubit $q_2$ of the array register as a target;

a CX gate that uses the superposition qubit $q_5$ of the full shift register as a control corresponding to a state of |1>, and the first ancilla qubit $a_1$ of the ancilla register as a target; and

a CX gate that uses the first qubit $q_1$ of the array register as a control corresponding to a state of |1>, and the first ancilla qubit $a_1$ of the ancilla register as a target,

wherein the X gate is applied to the first qubit $q_1$ of the array register.

As shown in FIG. 2C, the middle segment **206** comprises the two sets of CX gates and two-controlled gates. The number of sets in the middle segment **206** depends on the number of recursions, wherein k is initially equal to 1, and k is incremented by 1 with each recursion until k reaches 3. Thus, the value of k is equal to 2 and 3, respectively, for a first set and a second set from amongst the two sets of the middle segment **206** corresponding to a first recursion and a second recursion.

As shown in FIG. 2C, the first set comprises in a sequential order:

a first CX gate **2061a** that uses the superposition qubit $q_5$ of the full shift register as a control corresponding to a state of |1>, and the second qubit $q_2$ of the array register as a target;

a first two-controlled gate **2062a** that uses the second qubit $q_2$ of the array register and the first ancilla qubit $a_1$ of the ancilla register as controls corresponding to a state of |1>, and a second ancilla qubit $a_2$ of the ancilla register as a target;

a second CX gate **2063a** that uses the second ancilla qubit $a_2$ of the ancilla register as a control corresponding to a state of |1>, and a third qubit $q_3$ of the array register as a target;

a second two-controlled gate **2064a** that uses the second qubit $q_2$ of the array register and the first ancilla qubit $a_1$ of the ancilla register as controls corresponding to a state of |1>, and the second ancilla qubit $a_2$ of the ancilla register as a target; and

a third CX gate **2065a** that uses the superposition qubit $q_5$ of the full shift register as a control corresponding to a state of |1>, and the second qubit $q_2$ of the array register as a target.

In the middle segment **206,** the second set corresponding to the second recursion is appended after the first two-controlled gate **2062a** of the first set corresponding to the first recursion. As shown in FIG. 2C, the second set comprises in a sequential order:

a first CX gate **2061b** that uses the superposition qubit $q_5$ of the full shift register as a control corresponding to a state of |1>, and the third qubit $q_3$ of the array register as a target;

a first two-controlled gate **2062b** that uses the third qubit $q_3$ of the array register and the second ancilla qubit $a_2$ of the

ancilla register as controls corresponding to a state of |1>, and a third ancilla qubit $a_3$ of the ancilla register as a target;

a second CX gate **2063b** that uses the third ancilla qubit $a_3$ of the ancilla register as a control corresponding to a state of |1>, and a last qubit $q_4$ **of** the array register as a target;

a second two-controlled gate **2064b** that uses the third qubit $q_3$ of the array register and the second ancilla qubit $a_2$ of the ancilla register as controls corresponding to a state of |1>, and the third ancilla qubit $a_3$ of the ancilla register as a target; and

a third CX gate **2065b** that uses the superposition qubit $q_5$ of the full shift register as a control corresponding to a state of |1>, and the third qubit $q_3$ of the array register as a target.

In the example circuit of FIG. 2C, a first step of controlled inverting is applied on the last qubit $q_4$ of the array register, because this step of inverting starts with k = N - 1 = 3. Hence, a step size of a first substate shift is $2^k = 2^3 = 8$. As the first step of controlled inverting takes place after all decompositions are performed, the first substate shift applies only on those last substates of the decomposition (namely, the even substates and the odd substates with respect to the third qubit $q_3$). A second step of controlled inverting is applied on the third qubit $q_3$, as the value of k is 2 after a decrement. Hence, a step size of a second substate shift is $2^2 = 4$. The second substate shift applies only on the even substates and the odd substates with respect to the second qubit $q_2$. Likewise, a third step of controlled inverting is applied on the second qubit $q_2$, as the value of k is 1 after another decrement. Hence, a step size of a third substate shift is $2^1 = 2$. The third substate shift applies only on the even substates and the odd substates with respect to the first qubit $q_1$. Finally, the step of final inverting is performed by applying the X gate on the first qubit $q_1$. This finalizes the multi-step quantum basis state shift of the step size of 1 for the full state of the array register in this example quantum circuit. In FIGs. 2A-2C, each CX gate and the X gate that are applied for performing the steps of inverting have been surrounded by dashed lines.

It will be appreciated that in FIG. 2C, the step index 'i' has been taken as 0, so as to illustrate multiple recursions with a simplest example of the quantum circuit in which the full shift register has only five qubits. The quantum circuits of larger sizes and higher complexities can be built, based on a generalized implementation of the quantum circuit illustrated in FIGs. 2A-2B.

The multi-step quantum basis state shift implemented using such quantum circuits can be utilised in various quantum algorithms that include, for example, a quantum random walk or other related quantum applications. Notably, the multi-step quantum basis state shift can be advantageously implemented as a fundamental building block in a discrete quantum random walk, and subsequently adopted in several quantum algorithms. For example, the multi-step quantum basis state shift can be used to implement a propagation step in quantum algorithms for the quantum lattice Boltzmann method (QLBM) and the quantum lattice gas automata (QLGA).

Optionally, in this regard, the method further comprises executing a quantum algorithm by using the quantum circuit to perform the multi-step quantum basis state shift as a subroutine in the quantum algorithm. In a simplest implementation of the method, the quantum circuit is utilised to perform the multi-step quantum basis state shift in orthogonal directions on a polygonal lattice. It will be appreciated that the quantum circuit can be utilised to perform the multi-step quantum basis state shift in non-orthogonal directions on a polygonal lattice. Such multi-step quantum basis state shifts in polygonal lattices are of interest for several quantum algorithms, for example, such as lattice-based physics solvers that are employed to simulate physical processes. The QLBM and QLGA are some examples of such lattice-based physics solvers. Notably, such a simulation of a physical process often involves a quantum random walk or other related quantum applications. Thus, the quantum circuit of the present disclosure can be used to perform the multi-step quantum basis state shift as the subroutine in the quantum algorithm.

The quantum algorithm can be employed for various practical applications, where the quantum circuit provides clear computational advantages in various application areas, for example, such as cryptography and cybersecurity, drug discovery and molecular modelling, material science and engineering, financial modelling and risk analysis, machine learning and artificial intelligence, climate modelling and environmental analysis, and so on. Optionally, in this regard, the quantum algorithm is executed to perform a simulation of a physical process, wherein the method further comprises providing a user with measurements taken after the simulation of the physical process is performed. It will be appreciated that one or more state variables that are measured depend on the quantum algorithm as well as the physical process being simulated. As the multi-step quantum basis state shift can be performed in multiple shift directions in one go at a same computational complexity class as a single-step basis state shift, there is a significant quantum speedup. This allows for providing the user with the measurements very quickly. Notably, this allows for performing multiple simulations of the physical process with a high degree of parallelization. Due to the parallelization, an overall depth of the quantum algorithm is shallower, compared to a quantum algorithm that uses a single-step basis state shift. Advantageously, such a shallower quantum algorithm has simpler operations that tend to accumulate less noise and errors in the measurements.

There will now be described how the multi-step quantum basis state shift performed by utilising the aforementioned method compares with a quantum random walk, and can be implemented as a part of the quantum random walk. The multi-step quantum basis state shift pertains to a shift of the full state of the array register, which can be referred to as a full data array shift. While the quantum random walk is defined as a superposition of at least two full data array shifts, wherein an interpretation of walk probabilities depends on how the superposition is achieved.

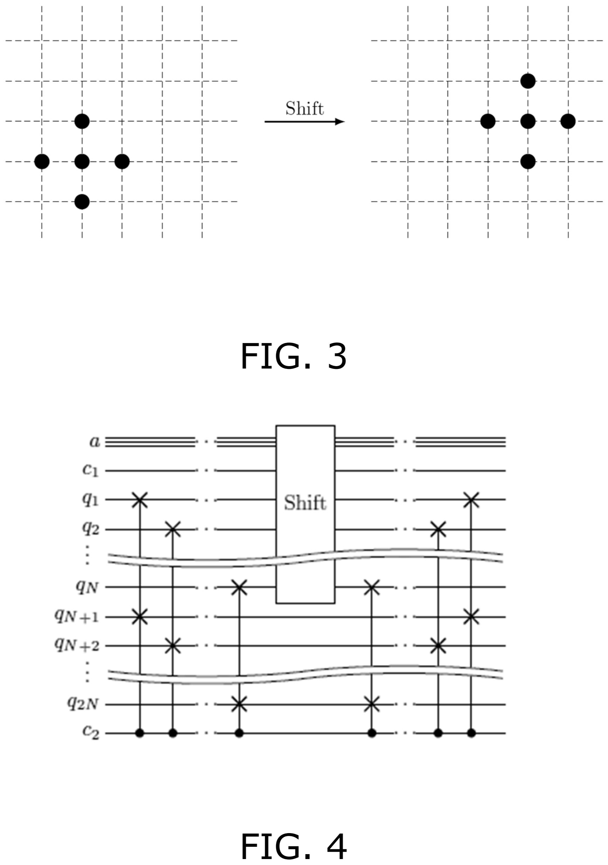

FIG. 3 depicts an example of a full data array shift, namely a combination of two multi-step quantum basis state shifts, which is interpreted as a location pattern on a two-dimensional lattice. In the example, the combination of the two multi-step quantum basis state shifts moves the full state of the array register by two steps towards a right direction and by one step towards an upward direction. The full state of the array register covers an entirety of the two-dimensional lattice; however, for illustration purposes only, some of the basis state have been marked as some of lattice points in the two-dimensional lattice. This could be interpreted as a presence of a particle at those lattice points. The phrase "the combination of the two multi-step quantum basis state shifts" means moving the full state on the two-dimensional lattice, as shown in FIG. 3; this could be interpreted as a movement of the particles. It will be appreciated that algorithmically, an entirety of the state vector space is moved in the lattice, and not just those lattice points that have non-trivial markings. In the context of performing said combination of the two multi-step quantum basis state shifts, this movement amounts to re-mapping the state amplitudes. For example, if basis states are indexed, an increment operator would move the state amplitudes to a next basis state according to the indexing.

The multi-step quantum basis state shift can be extended to a quantum random walk by defining a superposition of the full data of the state vector space in the lattice, representing different possibilities. As an example, consider a combination of two multi-step quantum basis state shifts with equal weights interpreted as a uniform probability for the particles moving either way. This is merely a simple example, but the superposition could be arbitrarily complex. For example, one of the particles could have distinct probabilities of appearing anywhere on the lattice, some of the particles could have distinct probabilities of moving just in the right direction, and so on.

For the sake of simplicity, the present disclosure focuses only on uniform superpositions of different movements in the multi-step quantum basis state shift. A simplest example of this is a uniform symmetric movement, wherein the superpositions pair symmetrically. This can be interpreted as a diffusion-like movement over a regular lattice. As explained earlier, the quantum circuit for such a uniform symmetric movement is very efficient, due to its inherent parallelizability. Such a uniform symmetric movement with parallelizability can also be referred to as a "parallel symmetric shift".

Throughout the present disclosure, canonical basis states are assumed to be 0 and 1, and corresponding tensor product basis states are assumed as bitstrings $q_m q_{m-1} ... q_1$, wherein $q_j \in \{0, 1\}$, wherein the rightmost bit is the least significant. In the quantum circuit figures, the least significant qubit is shown on the top. For indexing sets, finite subsets of N are used, with an assumption that the indexing starts from 1.

Moreover, it will be appreciated that a basis state shift is a Fredholm operator on the Hilbert space induced by the tensor product of qubits. In other words, for an indexed set of basis states $\{e_j\}^n_{j=1}$, the increment operator can be represented as follows:

$$S_+ : e_j \rightarrow e_{j+1}$$

and the decrement operator can be represented as follows:

$$S_- : e_j \rightarrow e_{j-1}$$

In the multi-step quantum basis state shift, there is a shift in arrays of state amplitudes, which are coefficients to basis states. Thus, the multi-step quantum basis state shift is moving the state amplitudes either forward or backward in a basis state index sequence:

$$S_\pm^k \left( \alpha^j e_j \right) \mapsto \alpha^{j \mp k} e_j, \quad \alpha^j \in \mathbb{C}, k \in \mathbb{N}.$$

Furthermore, it is assumed that the indexing of the basis states is isomorphic to the quotient group Z/nZ, wherein n is the size of the state vector space, and n = 2^N. This makes the shift periodic, and allows for interpreting the shift as an amplitude propagation on a cyclic one-dimensional graph. Notably, in a one-dimensional lattice, the parallel symmetric shift is performed as a bi-directional shift. This interpretation of the parallel symmetric shift can be easily expanded to higher dimensions in the sense of orthogonal lattices, as explained below.

In this regard, interpretations of the parallel symmetric shifts on a r-dimensional lattice (namely, r = 2 or 3) will now be considered. These interpretations are especially important for practical applications of the quantum circuit. As earlier, the parallel symmetric shifts are assumed to be periodic. However, such periodicity is assumed to be with respect to each spatial dimension, so that the indexing is isomorphic to (Z/nZ)^r, wherein the product is a Cartesian product of quotient groups and n is a size of a state vector subspace (of the state vector space) corresponding to one spatial dimension of an entirety of the state vector space, namely a length of a lattice side of the state vector subspace. For the sake of simplicity, the interpretations have been considered by assuming a square lattice (for r = 2) or a cubic lattice (for r = 3), and that n (namely, the size of the state vector subspace) is a power of two. Topologically, such lattices can be interpreted as discrete toroidal surfaces. Moreover, different directions along different dimensions of these lattices are considered to be orthogonal, merely to refer to the structure of these lattices. It will be appreciated that dimensions are not relevant for purposes of the present disclosure; instead, a fact that the directions are in some sense independent of each other is important to note.

The aforementioned parallel symmetric shift of the one-dimensional lattice can be adapted to the higher dimensions (namely, a two-dimensional lattice or a three-dimensional lattice) with some additional arrangement of the basis states. Optionally, in this regard, the method further comprises performing at least one additional multi-step quantum basis state shift having a size of $2^i$ (namely, a power of 2) for at least one additional dimension. In some implementations, the multi-step quantum basis state shift and the at least one additional multi-step quantum basis state shift are performed for one dimension and the at least one additional dimension, respectively, by stacking one-dimensional shifts in a sequence. Such stacking of one-dimensional multi-step quantum basis state shifts is performed by considering the array register (namely, an indexed array of basis states) to correspond to a plurality of stacks of one-dimensional data. This ensures a correct superposition of the "direction substates". It will be appreciated that this step can be performed using the steps of the method as described earlier with respect to the multi-step quantum basis state shift (namely, the parallel symmetric shift for the one-dimensional lattice). Hereinabove, for r = 2, the at least one additional dimension comprises a single additional dimension, and the at least one additional multi-step quantum basis state shift comprises a single additional multi-step quantum basis state shift. Similarly, for r = 3, the at least one additional dimension comprises two additional dimensions, and the at least one additional multi-step quantum basis state shift comprises two additional multi-step quantum basis state shifts.

A technical benefit of this is that the multi-step quantum basis state shift and the at least one additional multi-step quantum basis state shift can be performed at one go at a same computational complexity class as a single-step basis state shift. This technical benefit arises from the parallelization of several shifts under a single operation. Due to the parallelization, an overall depth of a quantum circuit for the multi-step quantum basis state shift and the at least one additional multi-step quantum basis state shift is shallower than twice of an overall depth of a quantum circuit for the single-step basis state shift. Moreover, it allows for having different step sizes in one go for different array substates corresponding to different dimensions.

It will be appreciated that for the r-dimensional lattice (having a dimension of r), the array register has rN qubits. Moreover, r superposition qubits are required to account for a simple orthogonal movement in all dimensions. Thus, the full shift register is required to have r(N+1) qubits, wherein the first rN qubits form the array register, while the last r qubits are the superposition qubits. The r superposition qubits allow for the superposition of directions along all the dimensions of the r-dimensional lattice.

In other implementations, the multi-step quantum basis state shift and the at least one additional multi-step quantum basis state shift are performed for the one dimension and the at least one additional dimension, respectively, by using controlled swap blocks to change a qubit ordering for corresponding substates in the multi-step quantum basis state shift and the at least one additional multi-step quantum basis state shift. In other words, only a single one-dimensional shift is performed with these controlled swap blocks. A technical benefit of using the controlled swap blocks is that they not only ensure a correct superposition of the "direction substates", but also are more efficient in lattices of larger sizes. It will be appreciated that although the controlled swap gates will add to the overall complexity of the quantum circuit, as compared to a single one-dimensional shift, the overall complexity stays linear.

FIG. 4 depicts a detailed diagram of a quantum circuit that uses two controlled swap blocks for performing two multi-step quantum basis state shifts in two dimensions, in accordance with an embodiment of the present disclosure. The two multi-step quantum basis state shifts allow for shifting symmetrically in four directions on a 2D regular lattice using the two controlled swap blocks. In reference to FIG. 4, a box marked **Shift** represents the quantum circuit for performing the multi-step quantum basis state shift (namely, as shown in FIGs. 2A and 2B). A first controlled swap block (out of the two controlled swap blocks) is applied before performing the multi-step quantum basis state shift, while a second controlled swap block is applied after performing the multi-step quantum basis state shift.

Most importantly, the array register has 2N qubits ($q_1$, $q_2$,... $q_{2N}$), wherein the quantum circuit for the multi-step quantum basis state shift is applied on a first half of the array register, namely the first N qubits ($q_1$, $q_2$,... $q_N$) of the array register, and a first superposition qubit ($c_1$) of a superposition register. The superposition register comprises two superposition qubits ($c_1$, $c_2$)., wherein a second superposition qubit ($c_2$) is employed to provide control for the two controlled swap blocks. In such an implementation, the full shift register comprises the array register ($q_1$, $q_2$,... $q_{2N}$) and the superposition register ($c_1$, $c_2$).

As shown in FIG. 4, each of the first controlled swap block and the second controlled swap block comprises N controlled swap gates. The N controlled swap gates of the first controlled swap block are arranged symmetrically with respect to the N controlled swap gates of the second controlled swap block. In the first controlled swap block, the N controlled swap gates comprise in a sequential order:

a first controlled swap gate that is applied between the first qubit $q_1$ of the array register and an $N+1^{th}$ qubit $q_{N+1}$ of the array register, and that uses the second superposition qubit $c_2$ of the superposition register as a control corresponding to the state of |1>;

a second controlled swap gate that is applied between the second qubit $q_2$ of the array register and an $N+2^{th}$ qubit $q_{N+2}$ of the array register, and that uses the second superposition qubit $c_2$ of the superposition register as a control corresponding to the state of |1>;

and so on, till

an $N^{th}$ controlled swap gate that is applied between the $N^{th}$ qubit $q_N$ of the array register and an $2N^{th}$ qubit $q_{2N}$ of the array register, and that uses the second superposition qubit $c_2$ of the superposition register as a control corresponding to the state of |1>.

In the second controlled swap block, the N controlled swap gates comprise in a sequential order:

a first controlled swap gate that is applied between the $N^{th}$ qubit $q_N$ of the array register and the $2N^{th}$ qubit $q_{2N}$ of the array register, and that uses the second superposition qubit $c_2$ of the superposition register as a control corresponding to the state of |1>;

a second controlled swap gate that is applied between an $N-1^{th}$ qubit $q_{N-1}$ of the array register and an $2N-1^{th}$ qubit $q_{2N-1}$ of the array register, and that uses the second superposition qubit $c_2$ of the superposition register as a control corresponding to the state of |1>;

and so on, till

an $N^{th}$ controlled swap gate that is applied between the first qubit $q_1$ of the array register and the $N+1^{th}$ qubit $q_{N+1}$ of the array register, and that uses the second superposition qubit $c_2$ of the superposition register as a control corresponding to the state of |1>.

EXPERIMENTAL PART

For practical implementations of the quantum circuit for performing the multi-step quantum basis state shift, it is important to understand the complexity of the quantum circuit in terms of required gates and qubits. In this regard, the gate complexity (namely, the complexity of the quantum circuit in terms of the required gates) has been measured as the number of CX gates with respect to the number of qubits, as CX gates (namely, one-qubit controlled X gates) are often regarded as a fundamental gate and have the highest gate infidelities in actual quantum computers of today.

The quantum circuit of the present disclosure has only X gate, CX gates and two-controlled gates (namely, Toffoli gates). It will be appreciated that the quantum circuit has the maximum number of gates when the step size $2^i$ is equal to 1, namely when i = 0. In order to calculate the gate complexity of the quantum circuit, there will now be considered different implementations of the quantum circuit for N > 1 and i = 0, wherein the size of the array register increases with an increase in a size of the state vector space, namely $2^N$.

In a first case of N = 1, the array register has only one qubit ($q_1$). In the first case, i = N - 1, and a first implementation of the quantum circuit comprises only one X gate.

In a second case of N = 2, the array register has two qubits ($q_1$, $q_2$). In the second case, i = N - 2, and a second implementation of the quantum circuit comprises five CX gates and one X gate. An arrangement of these five CX gates and the X gate in the second case may be considered as a foundational arrangement for larger circuits.

With each added qubit in the array register, namely for i < N - 2, a corresponding implementation of the quantum circuit comprises:

one CX for performing an additional substate shift, and

two Toffoli gates and two CX gates for performing an even/odd decomposition for the substates,

in addition to the five CX gates and the X gate of the foundational arrangement.

Using a minimum decomposition of a Toffoli gate into six CX gates and a few single-qubit gates, the corresponding implementation of the quantum circuit comprises 15 CX gates in addition to the five CX gates and the X gate of the foundational arrangement. Thus, the gate complexity (measured as the number of CX gates with respect to the number of qubits) for N > 1 and i = 0 can be represented as follows:

$$n_{CX}(N) = 15N - 25$$

Although each added qubit in the array register results in an addition of 15 CX gates to the quantum circuit, each increase in the step size also reduces 15 CX gates from the quantum circuit. Thus, in general, the gate complexity for any step size $2^i$ and i < N - 2 (or i = N - 2) can be represented as follows:

$$n_{CX}(N, i) = 15(N - i) - 25$$

It will be appreciated that the number of required ancilla qubits is N - i - 1.

Moreover, the gate complexity of the multi-step quantum basis state shift will now be compared with the following:

(i) a shift based on the quantum Fourier transformation, as proposed by Shakeel in "Efficient and scalable quantum walk algorithms via the quantum fourier transform", published in Quantum Information Processing 19 (2020); and
(ii) a parallel shift method, as proposed by Budinski et al. in "Efficient parallelization of quantum basis state shift", published in Quantum Science and Technology 8 (2023) 045031.

In following tables, 'QFT' denotes the aforesaid (i), 'Parallel' denotes the aforesaid (ii), and 'Parallel cascade' denotes the multi-step quantum basis state shift of the present disclosure. The number of CX gates are calculated by using ancilla decomposition and gate cancellation, where possible. All-to-all connectivity of qubits is assumed.

A first table below represents the gate complexity measured as the number of CX gates with respect to the number of qubits (N) of the array register and the step size $2^i$, for a bi-directional shift in a one-dimensional lattice. The number of qubits refers to the number of qubits used to encode the array register.

| #Qubits | Step size | #CX | | |
|---|---|---|---|---|
| | | QFT | Parallel | Parallel cascade |
| 10 | 1 | 200 | 229 | 125 |
| | 2 | - | 202 | 110 |
| | 4 | - | 175 | 95 |
| 15 | 1 | 450 | 364 | 200 |
| | 2 | - | 337 | 185 |
| | 4 | - | 310 | 170 |
| 20 | 1 | 800 | 499 | 275 |
| | 2 | - | 472 | 260 |
| | 4 | - | 445 | 245 |

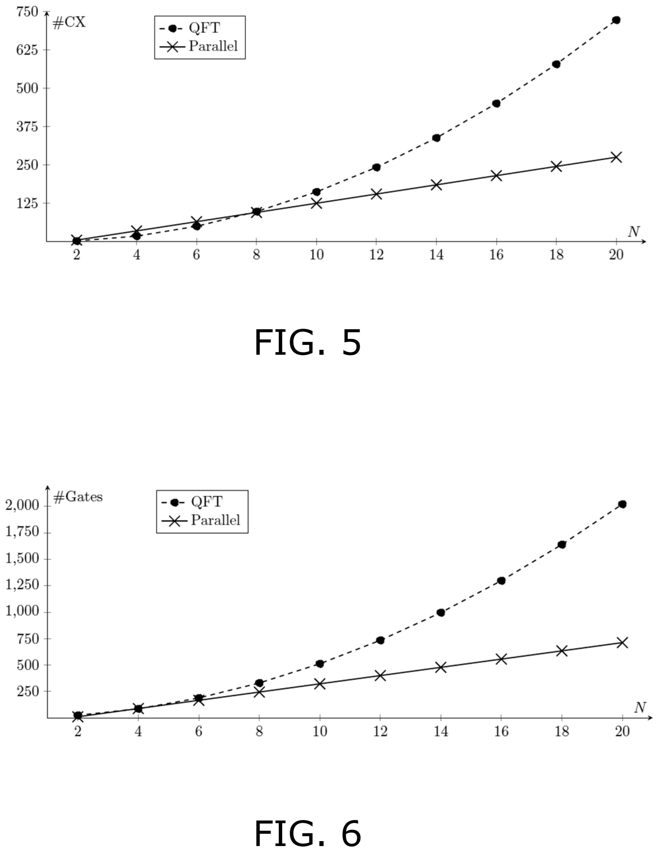

FIG. 5 depicts how the number of CX gates scales for different bidirectional shifts with a step size of one, relative to the number of qubits (N) that are used to encode the one-dimensional lattice. In FIG. 5, the scaling of the gate complexity has been shown for the aforesaid (i) (depicted by **QFT**) and the multi-step quantum basis state shift (denoted by 'Parallel cascade' in the first table, and depicted by **Parallel** in FIG. 5).

A second table below represents the gate complexity measured as the number of CX gates with respect to the number of qubits, for a two-dimensional array shift in four directions in a two-dimensional lattice. The two-dimensional extension is performed with controlled swap blocks for both shift variants. The number of qubits refers to the number of qubits used to encode one side of the lattice; therefore, the array register would require twice this number of qubits.

| #Qubits | #CX | | |
|---|---|---|---|
| | QFT | Parallel | Parallel cascade |
| 5 | 130 | 174 | 130 |

(continued)

| #Qubits | #CX | | |
|---|---|---|---|
| | QFT | Parallel | Parallel cascade |
| 10 | 360 | 389 | 285 |
| 15 | 690 | 604 | 440 |
| 20 | 1160 | 859 | 635 |

A third table below represents the gate complexity measured as the number of CX gates with respect to the number of qubits, for a three-dimensional array shift in six directions in a three-dimensional lattice. The three-dimensional extension is performed with controlled swap blocks for all shift variants. The number of qubits refers to the number of qubits used to encode one side of the lattice; therefore, the array register would require thrice this number of qubits.

| #Qubits | #CX | | |
|---|---|---|---|
| | QFT | Parallel | Parallel cascade |
| 5 | 210 | 254 | 210 |
| 10 | 520 | 549 | 445 |
| 15 | 930 | 844 | 680 |
| 20 | 1440 | 1139 | 915 |

Furthermore, in order to interpret the gate complexity of the multi-step quantum basis state shift for various practical implementations, an example implementation of the multi-step quantum basis state shift in a quantum random walk will next be compared with an example implementation of the aforesaid (i) (namely, QFT) in the quantum random walk. For the sake of simplicity, these example implementations are interpreted by assuming a trivial initial state and a quantum coin operator as the Hadamard gate, which sets an increment and a decrement into a uniform superposition. This interpretation is performed by employing a transpilation of corresponding quantum circuits with the basis gate set {CX, SX, RZ, ID} designed for the IBM Falcon quantum processor family, using the transpiler from Qiskit SDK in its default configuration. For the sake of simplicity, all-to-all connectivity of qubits is assumed.

In this regard, a fourth table below represents the gate complexity measured as the number of all the gates and the number of CX gates with respect to the number of qubits, for a bi-directional one-dimensional quantum walk. The number of qubits refers to the number of qubits used to encode the array register.

| #Qubits | #all gates | | #CX | |
|---|---|---|---|---|
| | QFT | Parallel cascade | QFT | Parallel cascade |
| 5 | 132 | 127 | 50 | 50 |
| 8 | 330 | 244 | 128 | 95 |
| 10 | 512 | 322 | 200 | 125 |
| 13 | 860 | 439 | 338 | 170 |
| 15 | 1142 | 517 | 450 | 200 |
| 20 | 2022 | 712 | 800 | 275 |

'FIG. 6 depicts how the total number of gates (namely, the number of all the gates) scales for the bi-directional one-dimensional quantum walk with a step size of one, relative to the number of qubits (N) that are used to encode the one-dimensional lattice. In FIG. 6, the scaling of the gate complexity has been shown for the aforesaid (i) (depicted by **QFT**) and the multi-step quantum basis state shift (denoted by 'Parallel cascade' in the fourth table, and depicted by **Parallel** in FIG. 6). A similar pattern can be observed when focusing only on the number of CX gates.

A fifth table below represents the gate complexity measured as the number of all the gates and the number of CX gates with respect to the number of qubits, for a two-dimensional quantum walk in four directions.

The two-dimensional extension is performed with controlled swap blocks for both shift variants. The number of qubits refers to the number of qubits used to encode one side of the lattice; the array register would require twice this number of qubits.

| #Qubits | #all gates | | #CX | |
|---|---|---|---|---|
| | QFT | Parallel cascade | QFT | Parallel cascade |
| 5 | 335 | 330 | 130 | 130 |
| 8 | 653 | 567 | 256 | 223 |
| 10 | 915 | 725 | 360 | 285 |
| 13 | 1383 | 962 | 546 | 378 |
| 15 | 1745 | 1120 | 690 | 440 |

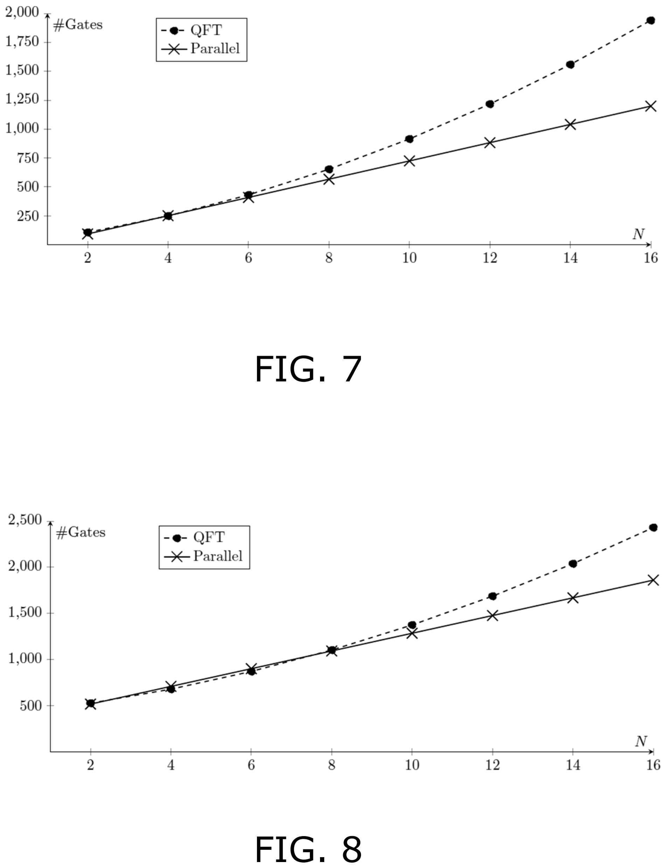

FIG. 7 depicts how the total number of gates (namely, the number of all the gates) scales for the two-dimensional quantum walk in four directions with a step size of one, relative to the number of qubits (N) that are used to encode one side of the lattice. In FIG. 7, the scaling of the gate complexity has been shown for the aforesaid (i) (depicted by **QFT**) and the multi-step quantum basis state shift (denoted by 'Parallel cascade' in the fourth table, and depicted by **Parallel** in FIG. 7). A similar pattern can be observed when focusing only on the number of CX gates.

Moreover, in order to interpret the gate complexity of the multi-step quantum basis state shift for the various practical implementations, another example implementation of the multi-step quantum basis state shift in a quantum lattice Boltzmann method (QLBM) will next be compared with another example implementation of the aforesaid (i) (namely, QFT) in the QLBM. The QLBM includes steps of collision, propagation, and macroscopics, which can be performed, for example, as explained in "Quantum algorithm for the advection-diffusion equation simulated with the lattice Boltzmann method", by Ljubomir Budinski, published in Quantum Information Processing (2021). These another example implementations are interpreted by assuming a trivial initial state, for the sake of clarity. This interpretation is performed by employing transpilation with a Qiskit default configuration. All-to-all connectivity of qubits is assumed.

In this regard, a sixth table below represents the gate complexity measured as the number of all the gates and the number of CX gates with respect to the number of qubits, for a two-dimensional QLBM model for the advection-diffusion equation (ADE) employed for the propagation step. This model has five possible directions for the shift, one of them implementing a stationary substate. The two-dimensional extension is performed with controlled swap blocks for both shift variants. The number of qubits refers to the number of qubits used to encode one side of the lattice; the array register would require twice this number of qubits.

| #Qubits | #all gates | | #CX | |
|---|---|---|---|---|
| | QFT | Parallel cascade | QFT | Parallel cascade |
| 5 | 770 | 805 | 261 | 272 |
| 8 | 1103 | 1093 | 393 | 380 |
| 10 | 1375 | 1285 | 501 | 452 |
| 13 | 1858 | 1573 | 693 | 560 |
| 15 | 2230 | 1765 | 841 | 632 |

In contrast to the two-dimensional quantum walk, the two-dimensional QLBM model for the advection-diffusion equation (ADE) employed for the propagation step requires additional controls for the stationary substate. It will be appreciated that any effect of an initial state preparation is excluded and a trivial initial state is assumed, for the sake of clarity. It will also be appreciated that the scaling of the overall complexity of this QLBM model is solely dependent on the propagation step, as all other steps of the quantum algorithm are constant for a given physics configuration. QLGA quantum circuits follow a similar pattern, as they are structurally similar to the QLBM. This highlights an importance of optimizing the multi-step quantum basis state shift.

FIG. 8 depicts how the total number of gates (namely, the number of all the gates) scales for the two-dimensional QLBM model for the ADE employed using different shifts for the propagation step, relative to the number of qubits (N) that are used to encode one side of the lattice. In FIG. 8, the scaling of the gate complexity has been shown for the aforesaid (i) (depicted by **QFT**) and the multi-step quantum basis state shift (denoted by 'Parallel cascade' in the fourth table, and depicted by **Parallel** in FIG. 8).

Furthermore, for an even more concrete analysis, a measured output distribution fidelity from a simulation is compared corresponding to an existing quantum device with superconducting qubits. This simulation takes into account reported gate errors, readout errors, and the actual qubit connectivity of the quantum device. There were used 2048 shots per simulation to map out the distributions for the QFT-based shift and the multi-step quantum basis state shift.

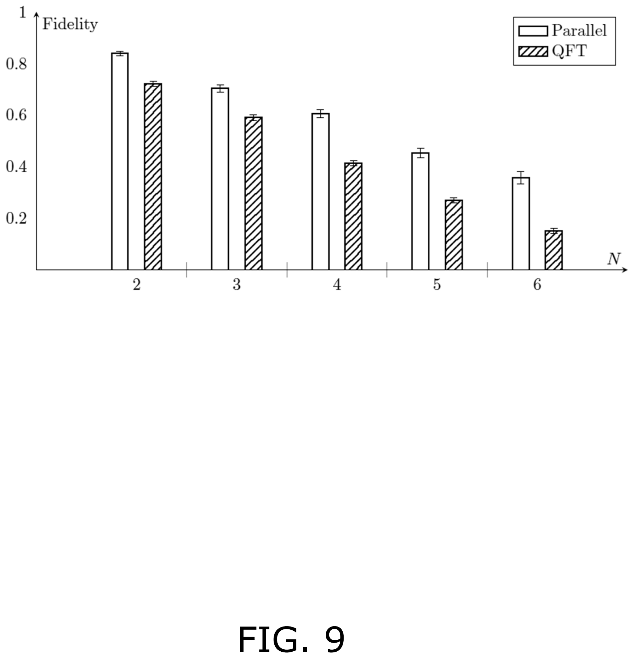

FIG. 9 depicts a circuit fidelity comparison of different bi-directional shifts with a step size of one, relative to the number of qubits N used to encode the one-dimensional lattice. The circuit fidelity comparison pertains to a comparison between a mean Hellinger fidelity with respect to an ideal distribution of these simulations along with a standard deviation, gathered from 20 repeated simulation runs. In particular, full state distributions from noisy device simulation are compared to an ideal noiseless distribution to calculate the Hellinger fidelity. These distributions were gathered from 2048 shots per simulation, and repeated 20 times to gain the Hellinger mean fidelity with standard deviation. In FIG. 9, the aforesaid (i) is depicted by **QFT,** while the multi-step quantum basis state shift is depicted by **Parallel.**

It is evident that the multi-step quantum basis state shift performs consistently better than the QFT shift even with these low qubit numbers. A larger deviation in the multi-step quantum basis state shift can be explained as an effect of the additional ancilla register; for a larger number of shots per simulation, this effect should diminish.

## Claims

1. A method being executed by a quantum computer or a quantum simulator, the method comprising:

setting up a full shift register and an ancilla register for a quantum circuit to be utilised for performing a multi-step quantum basis state shift in a state vector space having a size of $2^{N+1}$, wherein the full shift register comprises N+1 qubits, wherein first N qubits ($q_1$, $q_2$,... $q_N$) of the full shift register form an array register, and a last qubit ($q_{N+1}$) of the full shift register is a superposition qubit, and the ancilla register comprises at most N-1 ancilla qubits ($a_1$,... $a_{N-1}$);

dividing an input state comprising $2^{N+1}$ array substates into a first subset of array substates that are to be incremented and a second subset of array substates that are to be decremented, by considering an array substate whose superposition qubit ($q_{N+1}$) is 0 as an array substate to be incremented, and by considering an array substate whose superposition qubit ($q_{N+1}$) is 1 as an array substate to be decremented; and

for a step size of $2^i$ in the multi-step quantum basis state shift, where a step index 'i' is a non-negative integer less than N,

for i < N - 2, setting up the quantum circuit by:

decomposing the array substates of the first subset into even substates to be incremented and odd substates to be incremented, whilst decomposing the array substates of the second subset into even substates to be decremented and odd substates to be decremented, by considering a substate whose $k^{th}$ qubit ($q_k$) is 0 as an even substate, and by considering a substate whose $k^{th}$ qubit ($q_k$) is 1 as an odd substate, wherein k is equal to i+1;

re-mapping state amplitudes of the even substates to be decremented and the odd substates to be decremented;

recursively decomposing the odd substates to be incremented into further even substates to be incremented and further odd substates to be incremented, whilst recursively decomposing the even substates to be decremented into further even substates to be decremented and further odd substates to be decremented, by considering a substate whose $k^{th}$ qubit ($q_k$) is 0 as an even substate, and by considering a substate whose $k^{th}$ qubit ($q_k$) is 1 as an odd substate, wherein k is incremented by 1 with each recursion until k reaches N-1;

re-mapping state amplitudes of the further even substates to be decremented and the further odd substates to be decremented, after each recursion;

inverting the $k+1^{th}$ qubit ($q_{k+1}$) using a $k-i^{th}$ ancilla qubit ($a_{k-i}$) of the ancilla register as a control, to swap amplitude blocks of a size $2^k$ between adjacent even substates to be decremented with respect to the $k^{th}$ qubit ($q_k$), whilst swapping amplitude blocks of a size $2^k$ between adjacent odd substates to be incremented with respect to the $k^{th}$ qubit ($q_k$), wherein k is equal to N-1, and k is decremented by 1 with each recursion;

reversing the step of re-mapping the state amplitudes of the further even substates to be decremented and the further odd substates to be decremented;

reversing the step of recursively decomposing, wherein the step of inverting and the step of reversing the step of re-mapping are repeated prior to the reversing of each recursion of the step of recursively decomposing;

inverting the $k+1^{th}$ qubit ($q_{k+1}$) using a first ancilla qubit ($a_1$) of the ancilla register as a control, to swap amplitude blocks of a size $2^k$ between adjacent even substates to be decremented with respect to the $k^{th}$ qubit ($q_k$), whilst swapping amplitude blocks of a size $2^k$ between adjacent odd substates to be incremented with respect to the $k^{th}$ qubit ($q_k$), wherein k is equal to i+1;

reversing the step of re-mapping the state amplitudes of the even substates to be decremented and the odd substates to be decremented;

reversing the step of decomposing; and

inverting an $i+1^{th}$ qubit ($q_{i+1}$) to complete the multi-step quantum basis state shift of the state amplitudes according to the step size of $2^i$.

2. The method of claim 1, further comprising:
for i = N - 1, setting up the quantum circuit by:
inverting the i+1$^{th}$ qubit ($q_{i+1}$) to complete the multi-step quantum basis state shift of the state amplitudes according to the step size of $2^i$.

3. The method of any of the preceding claims, further comprising:
for i = N - 2, setting up the quantum circuit by:

decomposing the array substates of the first subset into even substates to be incremented and odd substates to be incremented, whilst decomposing the array substates of the second subset into even substates to be decremented and odd substates to be decremented, by considering a substate whose i+1$^{th}$ qubit ($q_{i+1}$) is 0 as an even substate, and by considering a substate whose i+1$^{th}$ qubit ($q_{i+1}$) is 1 as an odd substate;
re-mapping state amplitudes of the even substates to be decremented and the odd substates to be decremented;
inverting the i+2$^{th}$ qubit ($q_{i+2}$) using the first ancilla qubit ($a_1$) of the ancilla register as a control, to swap amplitude blocks of a size $2^{i+1}$ between adjacent even substates to be decremented with respect to the i+1$^{th}$ qubit ($q_{i+1}$), whilst swapping amplitude blocks of a size $2^{i+1}$ between adjacent odd substates to be incremented with respect to the i+1$^{th}$ qubit ($q_{i+1}$);
reversing the step of re-mapping the state amplitudes of the even substates to be decremented and the odd substates to be decremented;
reversing the step of decomposing; and
inverting the i+1$^{th}$ qubit ($q_{i+1}$) to complete the multi-step quantum basis state shift of the state amplitudes according to the step size of $2^i$.

4. The method of claim 1 or 3, wherein the quantum circuit comprises in a sequential order:

a beginning segment (202) comprising two CX gates (2021-2022);
optionally, a middle segment (206) comprising multiple CX gates and multiple two-controlled gates; and
an ending segment (204) comprising three CX gates (2041-2043) and an X gate (2044)

wherein the two CX gates (2021-2022) of the beginning segment (202) are applied in a sequential order of:

a CX gate (2021) that uses the i+1$^{th}$ qubit ($q_{i+1}$) of the array register as a control corresponding to a state of |1>, and a first ancilla qubit ($a_1$) of the ancilla register as a target; and
a CX gate (2022) that uses the superposition qubit ($q_{N+1}$) of the full shift register as a control corresponding to a state of |1>, and the first ancilla qubit ($a_1$) of the ancilla register as a target,

and wherein the three CX gates (2041-2043) of the ending segment (204) are applied in a sequential order of:

a CX gate (2041) that uses the first ancilla qubit ($a_1$) of the ancilla register as a control corresponding to a state of |1>, and an i+2$^{th}$ qubit ($q_{i+2}$) of the array register as a target;
a CX gate (2042) that uses the superposition qubit ($q_{N+1}$) of the full shift register as a control corresponding to a state of |1>, and the first ancilla qubit ($a_1$) of the ancilla register as a target; and
a CX gate (2043) that uses the i+1$^{th}$ qubit ($q_{i+1}$) of the array register as a control corresponding to a state of |1>, and the first ancilla qubit ($a_1$) of the ancilla register as a target,
wherein the X gate (2044) is applied to the i+1$^{th}$ qubit ($q_{i+1}$) of the array register.

5. The method of claim 4, wherein the middle segment (206) comprises one or more sets of CX gates and two-controlled gates, wherein a number of sets in the middle segment depends on a number of recursions of the step of recursively decomposing, wherein a given set corresponding to a given recursion comprises in a sequential order:

a first CX gate (2061, 2061a, 2061b) that uses the superposition qubit ($q_{N+1}$) of the full shift register as a control corresponding to a state of |1>, and a k$^{th}$ qubit ($q_k$) of the array register as a target;
a first two-controlled gate (2062, 2062a, 2062b) that uses the k$^{th}$ qubit ($q_k$) of the array register and a k-i-1$^{th}$ ancilla qubit ($a_{k-i-1}$) of the ancilla register as controls corresponding to a state of |1>, and a k-i$^{th}$ ancilla qubit ($a_{k-i}$) of the ancilla register as a target;
a second CX gate (2063, 2063a, 2063b) that uses the k-i$^{th}$ ancilla qubit ($a_{k-i}$) of the ancilla register as a control corresponding to a state of |1>, and an $k+1^{th}$ qubit ($q_{k+1}$) of the array register as a target;

a second two-controlled gate (2064, 2064a, 2064b) that uses the $k^{th}$ qubit ($q_k$) of the array register and the $k-i-1^{th}$ ancilla qubit ($a_{k-i-1}$) of the ancilla register as controls corresponding to a state of |1>, and the $k-i^{th}$ ancilla qubit ($a_{k-i}$) of the ancilla register as a target; and

a third CX gate (2065, 2065a, 2065b) that uses the superposition qubit ($q_{N+1}$) of the full shift register as a control corresponding to a state of |1>, and the $k^{th}$ qubit ($q_k$) of the array register as a target,

wherein an $M+1^{th}$ set corresponding to an $M+1^{th}$ recursion is appended after a corresponding first two-controlled gate (2062, 2062a) of an $M^{th}$ set corresponding to an $M^{th}$ recursion.

6. The method of any of the preceding claims, further comprising performing at least one additional multi-step quantum basis state shift having a size of $2^i$ for at least one additional dimension.

7. The method of claim 6, wherein the multi-step quantum basis state shift and the at least one additional multi-step quantum basis state shift are performed for one dimension and the at least one additional dimension, respectively, by stacking one-dimensional shifts in a sequence.

8. The method of claim 6, wherein the multi-step quantum basis state shift and the at least one additional multi-step quantum basis state shift are performed for the one dimension and the at least one additional dimension, respectively, by using controlled swap blocks to change a qubit ordering for corresponding substates in the multi-step quantum basis state shift and the at least one additional multi-step quantum basis state shift.

9. The method of any of the preceding claims, further comprising executing a quantum algorithm by using the quantum circuit to perform the multi-step quantum basis state shift as a subroutine in the quantum algorithm.

10. The method of claim 9, wherein the quantum algorithm is executed to perform a simulation of a physical process, wherein the method further comprises providing a user with measurements taken after the simulation of the physical process is performed.

11. A quantum computer or a quantum simulator configured to execute a method according to any of the preceding claims.

12. A quantum circuit executed by a quantum computer or a quantum simulator, the quantum circuit comprising a full shift register and an ancilla register to be utilised for performing a multi-step quantum basis state shift in a state vector space having a size of $2^{N+1}$, wherein the full shift register comprises N+1 qubits, wherein first N qubits ($q_1, q_2,... q_N$) of the full shift register form an array register, and a last qubit ($q_{N+1}$) of the full shift register is a superposition qubit, and the ancilla register comprises at most N-1 ancilla qubits ($a_1,... a_{N-1}$), wherein the quantum circuit comprises in a sequential order:

a beginning segment (202) comprising two CX gates (2021-2022);
optionally, a middle segment (206) comprising multiple CX gates and multiple two-controlled gates; and
an ending segment (204) comprising three CX gates (2041-2043) and an X gate (2044).

13. The quantum circuit of claim 12, wherein for a step size of $2^i$ in the multi-step quantum basis state shift, where a step index 'i' is a non-negative integer less than N,
for i < N - 2 or i = N - 2, the two CX gates (2021-2022) of the beginning segment (202) are applied in a sequential order of:

a CX gate (2021) that uses the $i+1^{th}$ qubit ($q_{i+1}$) of the array register as a control corresponding to a state of |1>, and a first ancilla qubit ($a_1$) of the ancilla register as a target; and
a CX gate (2022) that uses the superposition qubit ($q_{N+1}$) of the full shift register as a control corresponding to a state of |1>, and the first ancilla qubit ($a_1$) of the ancilla register as a target.

14. The quantum circuit of claim 12 or 13, wherein for a step size of $2^i$ in the multi-step quantum basis state shift, where a step index 'i' is a non-negative integer less than N,
for i < N - 2 or i = N - 2, the three CX gates (2041-2043) of the ending segment (204) are applied in a sequential order of:

a CX gate (2041) that uses the first ancilla qubit ($a_1$) of the ancilla register as a control corresponding to a state of |1>, and an $i+2^{th}$ qubit ($q_{i+2}$) of the array register as a target;
a CX gate (2042) that uses the superposition qubit ($q_{N+1}$) of the full shift register as a control corresponding to a state of |1>, and the first ancilla qubit ($a_1$) of the ancilla register as a target; and

a CX gate (2043) that uses the i+1$^{th}$ qubit ($q_{i+1}$) of the array register as a control corresponding to a state of |1>, and the first ancilla qubit ($a_1$) of the ancilla register as a target,

wherein the X gate (2044) is applied to the i+1$^{th}$ qubit ($q_{i+1}$) of the array register.

15. The quantum circuit of any of claims 12-14, wherein for a step size of $2^i$ in the multi-step quantum basis state shift, where a step index 'i' is a non-negative integer less than N,

for i < N - 2, the middle segment (206) comprises one or more sets of CX gates and two-controlled gates, wherein a number of sets in the middle segment depends on a number of recursions, wherein k is initially equal to i+1, and k is incremented by 1 with each recursion until k reaches N-1, wherein a given set corresponding to a given recursion comprises in a sequential order:

a first CX gate (2061, 2061a, 2061b) that uses the superposition qubit ($q_{N+1}$) of the full shift register as a control corresponding to a state of |1>, and a k$^{th}$ qubit ($q_k$) of the array register as a target;

a first two-controlled gate (2062, 2062a, 2062b) that uses the k$^{th}$ qubit ($q_k$) of the array register and a k-i-1$^{th}$ ancilla qubit ($a_{k-i-1}$) of the ancilla register as controls corresponding to a state of |1>, and a k-i$^{th}$ ancilla qubit ($a_{k-i}$) of the ancilla register as a target;

a second CX gate (2063, 2063a, 2063b) that uses the k-i$^{th}$ ancilla qubit ($a_{k-i}$) of the ancilla register as a control corresponding to a state of |1>, and an k+1$^{th}$ qubit ($q_{k+1}$) of the array register as a target;

a second two-controlled gate (2064, 2064a, 2064b) that uses the k$^{th}$ qubit ($q_k$) of the array register and the k-i-1$^{th}$ ancilla qubit ($a_{k-i-1}$) of the ancilla register as controls corresponding to a state of |1>, and the k-i$^{th}$ ancilla qubit ($a_{k-i}$) of the ancilla register as a target; and

a third CX gate (2065, 2065a, 2065b) that uses the superposition qubit ($q_{N+1}$) of the full shift register as a control corresponding to a state of |1>, and the k$^{th}$ qubit ($q_k$) of the array register as a target,

wherein an M+1$^{th}$ set corresponding to an M+1$^{th}$ recursion is appended after a corresponding first two-controlled gate (2062, 2062a) of an M$^{th}$ set corresponding to an M$^{th}$ recursion.

FIG. 1

FIG. 2A

FIG. 2B

FIG. 2C

FIG. 3

FIG. 4

FIG. 5

FIG. 6

FIG. 7

FIG. 8

FIG. 9

Europäisches
Patentamt

European
Patent Office

Office européen
des brevets

# EUROPEAN SEARCH REPORT

**Application Number**

EP 25 21 5979

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LJUBOMIR BUDINSKI ET AL: "Efficient parallelization of quantum basis state shift", ARXIV.ORG CORNELL UNIVERSITY LIBRARY, 201 OLIN LIBRARY CORNELL UNIVERSITY ITHACA, NY 14853, 4 April 2023 (2023-04-04), XP091476269, * Abstract * * p1-5,p7 * * figures 3-4 * ----- | 1-15 | INV. G06N10/20 G06N10/80 ADD. G06N10/60 G06N10/70 |
| A | WO 2024/165785 A1 (QUANSCIENT OY [FI]) 15 August 2024 (2024-08-15) * Abstract * * p27 * ----- | 1,11 | |

**TECHNICAL FIELDS SEARCHED (IPC)**

G06N

The present search report has been drawn up for all claims

| Place of search | Date of completion of the search | Examiner |
|---|---|---|
| The Hague | 17 April 2026 | Veynachter, Alexis |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 21 5979

This annex lists the patent family members relating to the patent documents cited in the above-mentioned European search report.
The members are as contained in the European Patent Office EDP file on
The European Patent Office is in no way liable for these particulars which are merely given for the purpose of information.

17-04-2026

| Patent document cited in search report | Publication date | Patent family member(s) | Publication date |
|---|---|---|---|
| WO 2024165785 A1 | 15-08-2024 | EP 4662603 A1<br>JP 2025540531 A<br>US 2024265285 A1<br>WO 2024165785 A1 | 17-12-2025<br>15-12-2025<br>08-08-2024<br>15-08-2024 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 11694107 B

**Non-patent literature cited in the description**

- **SHAKEEL**. Efficient and scalable quantum walk algorithms via the quantum fourier transform. *Quantum Information Processing*, 2020, vol. 19

- **LJUBOMIR BUDINSKI**. Quantum algorithm for the advection-diffusion equation simulated with the lattice Boltzmann method. *Quantum Information Processing*, 2021